(19) Europäisches Patentamt / European Patent Office / Office européen des brevets

(11) **EP 4 567 442 A1**

(12) **EUROPEAN PATENT APPLICATION**
published in accordance with Art. 153(4) EPC

(43) Date of publication:
**11.06.2025 Bulletin 2025/24**

(21) Application number: **23859200.0**

(22) Date of filing: **22.08.2023**

(51) International Patent Classification (IPC):
***G01R 31/34*** (2020.01)

(52) Cooperative Patent Classification (CPC):
**G01R 31/34**

(86) International application number:
**PCT/CN2023/114145**

(87) International publication number:
**WO 2024/046166 (07.03.2024 Gazette 2024/10)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **30.08.2022 CN 202211048338**

(71) Applicant: **Huawei Technologies Co., Ltd.**
**Shenzhen, Guangdong 518129 (CN)**

(72) Inventors:
• **WANG, Meng**
  **Shenzhen, Guangdong 518129 (CN)**
• **MENG, Chao**
  **Shenzhen, Guangdong 518129 (CN)**
• **CHEN, Runchang**
  **Shenzhen, Guangdong 518129 (CN)**

(74) Representative: **Pfenning, Meinig & Partner mbB**
**Patent- und Rechtsanwälte**
**Theresienhöhe 11a**
**80339 München (DE)**

(54) **FAULT MEASUREMENT METHOD AND RELATED APPARATUS**

(57) A fault detection method is provided. The method includes: obtaining a first current of a motor; obtaining first feature data of the first current based on the first current, where the first feature data is related to a fault of the motor, the first feature data is numerical relationships between a plurality of first harmonic amplitudes and a plurality of first amplitudes of the first current, the plurality of first amplitudes include a first fundamental amplitude and a plurality of second harmonic amplitudes of the first current, and the plurality of second harmonic amplitudes are unrelated to the fault of the motor; and determining a fault degree of the motor based on the first feature data. **In** this application, a degree of a potential fault existing in the motor may be determined based on the feature data.

Obtain a first current, where the first current is a stator current of a motor — 801

Obtain first feature data of the first current based on the first current, where the first feature data is related to a fault of the motor, the first feature data is numerical relationships between a plurality of first harmonic amplitudes and a plurality of first amplitudes of the first current, the plurality of first amplitudes include a first fundamental amplitude and a plurality of second harmonic amplitudes of the first current, and the plurality of second harmonic amplitudes are unrelated to the fault of the motor — 802

Determine a fault degree of the motor based on the first feature data — 803

FIG. 8

Processed by Luminess, 75001 PARIS (FR)

## Description

This application claims priority to Chinese Patent Application No. 202211048338.5, filed with the China National Intellectual Property Administration on August 30, 2022 and entitled "FAULT DETECTION METHOD AND RELATED APPARATUS", which is incorporated herein by reference in its entirety.

## TECHNICAL FIELD

This application relates to the field of fault detection, and in particular, to a fault detection method and a related apparatus.

## BACKGROUND

A motor is the most common device for driving various machinery in a production process. The motor is widely used in industrial production, transportation, infrastructure construction, agricultural development, and daily life. Power consumption of the motor accounts for more than 80% of total production power consumption. As a kind of electrical device that provides power for a plurality of industries, the motor has many potential fault factors, and a shutdown and production interruption caused by a fault brings a great economic loss. If the fault of the motor can be discovered in time, and repairing and maintenance can be performed in an early stage of the fault of the motor, a service life of the motor can be extended effectively, and reliability and stability of an entire production system can be improved.

To ensure stable operation of the motor, various sensors are set to monitor various parameter values of the motor. If some parameter values exceed preset values of a relay, the relay will give an alarm, and stop operation of the motor by cutting off a control loop of the motor when necessary, to prevent further escalation of a production accident.

On the surface, protection settings of the motor seem to be perfect, but in actual operation, the relay gives the alarm only when the motor is faulty. However, if the motor is suddenly powered off or suddenly stops operating, a great loss will be caused. Therefore, it is necessary to identify a potential fault existing in the motor. It should be understood that, that a potential fault exists in the motor does not mean that the fault has occurred in the motor, but means a deterioration phenomenon that appears before the fault occurs. To identify the potential fault existing in the motor, a method for determining a fault degree of the motor is urgently needed, so that the potential fault of the motor can be identified.

## SUMMARY

This application provides a fault detection method, to determine a degree of a potential fault existing in a motor.

A first aspect of this application provides a fault detection method. The method includes: obtaining a first current, where the first current is a stator current of a motor; obtaining first feature data of the first current based on the first current, where the first feature data is related to a fault of the motor, the first feature data is numerical relationships between a plurality of first harmonic amplitudes and a plurality of first amplitudes of the first current, the plurality of first amplitudes include a first fundamental amplitude and a plurality of second harmonic amplitudes of the first current, the plurality of first harmonic amplitudes are related to the fault of the motor, and the plurality of second harmonic amplitudes are unrelated to the fault of the motor; and determining a fault degree of the motor based on the first feature data.

For different motors or a same motor in different operating environments such as different working conditions, fault-related harmonic components in a stator current may differ due to noise such as a working condition. In other words, even if fault degrees of the motor are the same, magnitudes of fault-related harmonics may be different for different motors or different working conditions. To eliminate impact of different working conditions or different motors on a magnitude of a harmonic current, in this application, an amplitude of a fault-related harmonic current, a fundamental obtained by decomposing the stator current, and a harmonic unrelated to the fault are used as feature representation to determine the fault degree, so that an accurate fault degree can be determined by eliminating impact of different working conditions or different motors on the magnitude of the harmonic current.

In a possible implementation, to detect the fault of the motor, related operating parameters during operation of the motor may be analyzed. In the operating parameters of the motor, the stator current is a relatively sensitive state parameter inside the motor, and is easily obtained as a non-intrusive sensing signal and may be directly collected in a power distribution cabinet. In this embodiment of this application, a harmonic component of the stator current may be analyzed to determine a fault degree of the motor. When a potential fault occurs in the motor, an air gap of a magnetic field of the motor is uneven. The foregoing phenomenon is directly reflected in the stator current. For example, there may be a significant harmonic component in the current, or instability in phase value fluctuations. In this application, feature data in a signal (stator current) caused by the potential fault of the motor is extracted. The feature data reflects an abnormal component in the stator current, and a degree of the potential fault existing in the motor may be determined based on the feature data.

In some cases, a current value part or a current value abnormality (an abnormal state such as an obvious value jump exists) occurs in one or more phases of three-phase electricity. To improve accuracy of the collected stator current, for a missing part or an abnormal part of a specific-phase current, corresponding current values of another phase or other two phases may be used for supplement (because currents of different phases of the three-phase electricity are only different in phase but have a same amplitude under normal circumstances). For example, if a plurality of phases of currents are collected, signal preprocessing may be performed based on a correlation between the currents. For example, amplitudes of aligned phases in a plurality of phases (for example, two or three phases) of the three-phase electricity may be fused as the first current.

For example, the fusion may be splicing or averaging of amplitudes of different phases.

In a possible implementation, the numerical relationships between the plurality of first harmonic amplitudes and the plurality of first amplitudes include: a first difference degree between a first fusion result and a second fusion result, where the first fusion result is a fusion result of the plurality of first harmonic amplitudes, and the second fusion result is a fusion result of the plurality of first amplitudes.

The fusion result (for example, the first fusion result in this embodiment of this application) of the plurality of first harmonic amplitudes related to the potential fault of the motor may represent energy related to the potential fault of the motor, while the fusion result (for example, the second fusion result in this embodiment of this application) of the plurality of amplitudes may represent total energy (for example, total energy including the energy related to the fault, or total energy excluding the energy related to the fault). Therefore, the numerical relationships between the plurality of first harmonic amplitudes and the plurality of first amplitudes are a numerical relationship between the energy related to the potential fault of the motor and the total energy, which can represent the degree of the potential fault existing in the motor.

In a possible implementation, the first current is a stator current of the motor in a first time period, and the method further includes: obtaining a second current, where the second current is a stator current of the motor during normal operation or in a second time period, and the second time period is a time period before the first time period; and the determining a fault degree of the motor based on the first feature data includes: obtaining second feature data of the second current based on the second current, where the second feature data and the first feature data are data obtained through calculation in a same manner; and determining the fault degree of the motor based on a difference between the first feature data and the second feature data.

In a possible implementation, the first time period may be a continuous time period or a plurality of moments in a continuous time period, or the first time period may be a discontinuous time period or a plurality of moments in a discontinuous time period. This is not limited herein. For example, the first current may be a current instantaneous value at each of a plurality of moments in a time period.

In a possible implementation, amplitudes of fundamentals or harmonics of different motors or a same motor in different operating environments may be different. The degree of the potential fault existing in the motor cannot be accurately described by using only feature data of the motor during a specific time period.

In this application, to adapt to different motors or different motor operating environments, feature data of the motor during normal operation or in a historical operating time period may be used as a baseline, and the degree of the potential fault of the motor is determined by comparing real-time feature data of the motor with the baseline, so that difference interference of different motors or a same motor in different operating environments can be reduced.

In a possible implementation, the second feature data and the first feature data are data obtained through calculation in a same manner. Specifically, the plurality of first harmonic amplitudes are amplitudes of a plurality of first-frequency harmonics in the first current. The second feature data is numerical relationships between a plurality of third harmonic amplitudes of the plurality of first-frequency harmonics and a plurality of second amplitudes of the second current, the plurality of third harmonic amplitudes are amplitudes of the plurality of first-frequency harmonics in the second current, the plurality of second amplitudes include a fundamental amplitude and a plurality of harmonic amplitudes of the second current, the plurality of harmonic amplitudes are unrelated to the fault of the motor, and the second current is the stator current of the motor in the absence of fault or in the second time period.

In a possible implementation, each of the plurality of first harmonic amplitudes and each of a plurality of corresponding fourth harmonic amplitudes are within a preset numerical range, and each fourth harmonic amplitude is an amplitude of a harmonic of a multiplied frequency of a harmonic frequency corresponding to the first harmonic amplitude; or a fusion result of the plurality of first harmonic amplitudes and the plurality of corresponding fourth harmonic amplitudes is within a preset value range.

Not all harmonics are related to the potential fault existing in the motor, and some harmonics also exist when the motor operates normally (for example, due to a working condition of the motor). To analyze the degree of the potential fault existing in the motor, harmonics that are in a plurality of harmonics and that are related to the potential fault existing in the motor may be identified.

However, due to factors such as a motor operating environment, some harmonic amplitudes may meet the foregoing preset condition, but this is not caused by the potential fault of the motor, but caused by the motor operating environment, which leads to a misjudgment. To resolve this problem, in this embodiment of this application, a non-noise harmonic component can be accurately extracted by using a harmonic product spectrum. A principle is as follows: Noise usually generates only a single harmonic. In addition to generating harmonics at a point of a fault frequency, the fault further generates harmonic components at a multiplied-frequency position of the fault frequency. Through fusion, a harmonic feature related to the potential fault of the motor may be amplified and noise can be removed.

In other words, after the first current is processed, feature data of the first current may be obtained. The feature data includes an amplitude of a fundamental (for example, the first fundamental amplitude in this embodiment of this application) and amplitudes of a plurality of harmonics (for example, the plurality of first harmonic amplitudes in this embodiment of this application) of the first current. The plurality of first harmonic amplitudes in the plurality of first harmonic amplitudes are amplitudes of harmonics related to the potential fault existing in the motor. In addition, a fusion result (for example, the fusion result may be obtained through a product operation, a neural network, or the like) of each of the plurality of first harmonic amplitudes and the plurality of corresponding fourth harmonic amplitudes meets a preset condition, or each of the plurality of first harmonic amplitudes and each of the plurality of corresponding fourth harmonic amplitudes meet the preset condition. Each fourth harmonic amplitude is an amplitude of a harmonic of a multiplied frequency of a harmonic frequency corresponding to the first harmonic amplitude, and the preset condition may be that a value is greater than a threshold. Through the foregoing manner, a misjudgment caused by a factor such as a motor operating environment can be eliminated, and a harmonic related to the potential fault of the motor can be accurately identified.

The fusion result (for example, the fusion result may be obtained through a product operation, a neural network, or the like) of each of the plurality of first harmonic amplitudes and the plurality of corresponding fourth harmonic amplitudes meets the preset condition, and each fourth harmonic amplitude is an amplitude of a harmonic of a multiplied frequency of a harmonic frequency corresponding to the first harmonic amplitude. Through the foregoing manner, a misjudgment caused by a factor such as a motor operating environment can be eliminated, and a harmonic related to the potential fault of the motor can be accurately identified.

In addition, frequencies of harmonics related to potential faults existing at locations of different structures on the motor are different, and there is a correspondence (between a structure of the motor and a harmonic frequency). Different motors have different motor structures, and correspondences between structures and harmonic frequencies may also be different. In a conventional technology, for different motors, a correspondence between a structure of the motor and a harmonic frequency may be used as prior information. Whether a harmonic frequency is abnormal is analyzed to determine which structures of the motor are abnormal. However, even if a value of a corresponding frequency that does not belong to the motor structure in the correspondence is greater than a specific threshold, it is considered that the frequency is not a harmonic frequency corresponding to a faulty component. In other words, the conventional technology relies on prior information for fault detection. In this embodiment of this application, faulty components of the motor do not need to be located, and only frequencies of harmonics related to the fault need to be determined. Therefore, by using the foregoing method for determining a value of the harmonic of the multiplied frequency, faulty components can be accurately determined without relying on prior information.

In a possible implementation, a degree of the existing potential fault may be represented by a potential fault level, for example, severe, moderate, or minor.

In a possible implementation, a degree of the existing potential fault may be represented by a potential fault score, for example, a value between 0 and 100.

In a possible implementation, a degree of the existing potential fault may be represented by information about comparison between the degree of the potential fault of the electrode and a degree of a potential fault of another motor, for example, rankings of potential fault degrees of the motor.

According to a second aspect, this application provides a fault detection method. The method includes: obtaining a first current, where the first current is a stator current of a motor; obtaining first feature data of the first current based on the first current, where the first feature data includes a first variation feature, in time domain, of a first phase value corresponding to the first current, the first phase value is a phase in a complex signal obtained by decomposing the first current, and the first variation feature is related to a variation amplitude of the first phase value in time domain; and determining a fault degree of the motor based on the first feature data.

In a possible implementation, the feature data includes a first variation feature, in time domain, of a first phase value corresponding to the first current, and the phase value is a phase in a complex signal obtained by decomposing the first current. Optionally, the first variation feature may be related to a variation amplitude of the first phase value in time domain. For example, the variation amplitude may be represented by an average value of peak-to-peak values.

In a possible implementation, the first current is a stator current of the motor in a first time period, and the method further includes: obtaining a second current, where the second current is a stator current of the motor during normal operation or in a second time period, and the second time period is a time period before the first time period. The determining a fault degree of the motor based on the first feature data includes: obtaining second feature data of the second current based on the second current, where the second feature data and the first feature data are data obtained through calculation in a same manner; and determining the fault degree of the motor based on a difference between the first feature data and the second feature data.

In a possible implementation, the second feature data includes a second variation feature, in time domain, of a second phase value corresponding to the second current, the second phase value is a phase in a complex signal obtained by decomposing the second current, and the second variation feature is related to a variation amplitude of the second phase value in time domain.

In a possible implementation, the existing fault degree is represented by a fault level, a fault score, or information about comparison between the fault degree of the electrode and a fault degree of another motor.

According to a third aspect, this application provides a fault detection apparatus, where the apparatus includes:

an obtaining module, configured to obtain a first current, where the first current is a stator current of a motor;

a feature extraction module, configured to obtain first feature data of the first current based on the first current, where the first feature data is related to a fault of the motor, the first feature data is numerical relationships between a plurality of first harmonic amplitudes and a plurality of first amplitudes of the first current, the plurality of first amplitudes include a first fundamental amplitude and a plurality of second harmonic amplitudes of the first current, and the plurality of second harmonic amplitudes are unrelated to the fault of the motor; and

a fault determining module, configured to determine a fault degree of the motor based on the first feature data.

In a possible implementation, the first current is a stator current of the motor in a first time period, and the obtaining module is further configured to:

obtain a second current, where the second current is a stator current of the motor during normal operation or in a second time period, and the second time period is a time period before the first time period.

The feature extraction module is further configured to:

obtain second feature data of the second current based on the second current, where the second feature data and the first feature data are data obtained through calculation in a same manner.

The fault determining module is specifically configured to:

determine the fault degree of the motor based on a difference between the first feature data and the second feature data.

In a possible implementation, the numerical relationships between the plurality of first harmonic amplitudes and the plurality of first amplitudes include:

a first difference degree between a first fusion result and a second fusion result, where the first fusion result is a fusion result of the plurality of first harmonic amplitudes, and the second fusion result is a fusion result of the plurality of first amplitudes.

In a possible implementation, the plurality of first harmonic amplitudes are amplitudes of a plurality of first-frequency harmonics in the first current.

The second feature data is numerical relationships between a plurality of third harmonic amplitudes and a plurality of second amplitudes of the second current. The plurality of second amplitudes include a fundamental amplitude and a plurality of harmonic amplitudes of the second current. The second current is the stator current of the motor in the absence of fault or in the second time period. The plurality of third harmonic amplitudes are amplitudes of the plurality of first-frequency harmonics in the plurality of second amplitudes.

In a possible implementation, each of the plurality of first harmonic amplitudes and each of a plurality of corresponding fourth harmonic amplitudes are within a preset numerical range, and each fourth harmonic amplitude is an amplitude of a harmonic of a multiplied frequency of a harmonic frequency corresponding to the first harmonic amplitude; or

a fusion result of the plurality of first harmonic amplitudes and the plurality of corresponding fourth harmonic amplitudes is within a preset value range.

In a possible implementation, the existing fault degree is represented by a fault level, a fault score, or information about comparison between the fault degree of the electrode and a fault degree of another motor.

According to a fourth aspect, this application provides a fault detection apparatus. The apparatus includes:

an obtaining module, configured to obtain a first current, where the first current is a stator current of a motor;

a feature extraction module, configured to obtain first feature data of the first current based on the first current, where the first feature data includes a first variation feature, in time domain, of a first phase value corresponding to the first current, the first phase value is a phase in a complex signal obtained by decomposing the first current, and the first variation feature is related to a variation amplitude of the first phase value in time domain; and

a fault determining module, configured to determine a fault degree of the motor based on the first feature data.

In a possible implementation, the first current is a stator current of the motor in a first time period, and the obtaining module is further configured to:

obtain a second current, where the second current is a stator current of the motor during normal operation or in a second time period, and the second time period is a time period before the first time period.

The feature extraction module is further configured to:

obtain second feature data of the second current based on the second current, where the second feature data and the first feature data are data obtained through calculation in a same manner.

The fault determining module is specifically configured to:
determine the fault degree of the motor based on a difference between the first feature data and the second feature data.

In a possible implementation, the second feature data includes a second variation feature, in time domain, of a second phase value corresponding to the second current, the second phase value is a phase in a complex signal obtained by decomposing the second current, and the second variation feature is related to a variation amplitude of the second phase value in time domain.

In a possible implementation, the existing fault degree is represented by a fault level, a fault score, or information about comparison between the fault degree of the electrode and a fault degree of another motor.

In a possible implementation, a current value part or a current value abnormality (an abnormal state such as an obvious value jump exists) occurs in one or more phases of three-phase electricity. To improve accuracy of the collected stator current, for a missing part or an abnormal part of a specific-phase current, corresponding current values of another phase or other two phases may be used for supplement (because currents of different phases of the three-phase electricity are only different in phase but have a same amplitude under normal circumstances). For example, if a plurality of phases of currents are collected, signal preprocessing may be performed based on a correlation between the currents. For example, amplitudes of aligned phases in a plurality of phases (for example, two or three phases) of the three-phase electricity may be fused as the first current.

According to a fifth aspect, an embodiment of this application provides a fault detection device. The fault detection device may include a memory, a processor, and a bus system. The memory is configured to store a program. The processor is configured to execute the program in the memory, to perform the method according to the first aspect and any optional implementation of the first aspect, and the method according to the second aspect and any optional implementation of the second aspect.

According to a sixth aspect, an embodiment of this application provides a computer-readable storage medium. The computer-readable storage medium stores a computer program. When the computer program is run on a computer, the computer is enabled to perform the method according to the first aspect and any optional implementation of the first aspect, and the method according to the second aspect and any optional implementation of the second aspect.

According to a seventh aspect, an embodiment of this application provides a computer program. When the computer program is run on a computer, the computer is enabled to perform the method according to the first aspect and any optional implementation of the first aspect, and the method according to the second aspect and any optional implementation of the second aspect.

According to an eighth aspect, this application provides a chip system. The chip system includes a processor. The processor is configured to support an execution device or a training device in implementing functions in the foregoing aspects, for example, sending or processing data or information in the foregoing methods. In a possible design, the chip system further includes a memory. The memory is configured to store program instructions and data that are necessary for the execution device or the training device. The chip system may include a chip, or may include a chip and another discrete component.

## BRIEF DESCRIPTION OF DRAWINGS

FIG. 1 and FIG. 2 are diagrams of a framework of an application system according to the present invention;
FIG. 3 is a diagram of an optional hardware structure of a terminal;
FIG. 4 is a diagram of a structure of a server;
FIG. 5 is a diagram of fault warning;
FIG. 6 shows a cloud service process;
FIG. 7 is a diagram of a framework of an application system according to the present invention;
FIG. 8 is a schematic flowchart of a fault detection method according to an embodiment of this application;
FIG. 9 is a diagram of a product spectrum according to an embodiment of this application;
FIG. 10 is a diagram of determining a fault degree according to an embodiment of this application;
FIG. 11 is a schematic flowchart of a fault detection method according to an embodiment of this application;
FIG. 12 is a diagram of a fault degree according to an embodiment of this application;
FIG. 13 is a schematic flowchart of a fault detection method according to an embodiment of this application;
FIG. 14 and FIG. 15 are diagrams of structures of data processing apparatuses according to an embodiment of this application;
FIG. 16 is a diagram of a structure of an execution device according to an embodiment of this application;
FIG. 17 is a diagram of a structure of a training device according to an embodiment of this application; and

FIG. 18 is a diagram of a structure of a chip according to an embodiment of this application.

## DESCRIPTION OF EMBODIMENTS

The following describes embodiments of the present invention with reference to the accompanying drawings in embodiments of the present invention. Terms used in implementations of the present invention are merely intended to explain specific embodiments of the present invention, and are not intended to limit the present invention.

In the specification, claims, and accompanying drawings of this application, terms such as "first" and "second" are intended to distinguish between similar objects, but do not necessarily indicate a specific order or sequence. It should be understood that the terms used in such a way are interchangeable in proper circumstances, which is merely a discrimination manner that is used when objects having a same attribute are described in embodiments of this application. In addition, terms "include", "contain" and any other variants mean to cover a non-exclusive inclusion, so that a process, method, system, product, or device that includes a series of units is not necessarily limited to those units, but may include other units not expressly listed or inherent to such a process, method, system, product, or device.

Terms "substantially (substantially)", "about (about)", and similar terms are used in this specification as approximate terms rather than as degree terms, and are intended to take into account inherent deviations of measured values or calculated values that are known to those of ordinary skill in the art. In addition, when embodiments of the present invention are described, "may (may)" is used to mean "one or more possible embodiments". Terms "use (use)", "using (using)", and "used (used)" that are used in this specification may be considered to be synonymous with terms "utilize (utilize)", "utilizing (utilizing)", and "utilized (utilized)", respectively. In addition, the term "exemplary (exemplary)" is intended to refer to an instance or an example.

Application scenarios of this application are first described. This application may be but is not limited to being applied to a motor-type fault detection application, a cloud service provided by a cloud-side server, or the like. The following separately describes the application scenarios.

### 1. Fault detection application

A product form in embodiments of this application may be a fault detection application. A fault detection application may run on a terminal device or a cloud-side server.

In a possible implementation, the fault detection application may execute a fault detection task of a motor based on operation data of the motor. The fault detection application may respond to the input operation data of the motor (for example, a stator current of the motor).

In a possible implementation, a user may open the fault detection application installed on the terminal device, and input the operation data of the motor. The fault detection application may process the operation data of the motor by using the method provided in embodiments of this application, and present a fault detection result to the user.

For example, the fault detection result may be a degree of a fault that occurs in the motor.

In a possible implementation, the user may open the fault detection application installed on the terminal device, and input the operation data of the motor. The fault detection application may send the operation data of the motor to the cloud-side server. The cloud-side server processes the operation data of the motor by using the method provided in embodiments of this application, and returns the fault detection result to the terminal device. The terminal device may present the fault detection result to the user.

In a possible implementation, the user may open the fault detection application installed on the terminal device, and input the operation data of the motor. The terminal device on which the fault detection application is installed may reserve a title corresponding to the operation data of the motor in advance. Therefore, active input by the user may not be required. The fault detection application may send the operation data of the motor to the cloud-side server. The cloud-side server processes the operation data of the motor by using the method provided in embodiments of this application, and returns the fault detection result to the terminal device. The terminal device may present the fault detection result to the user.

The following describes the fault detection application in embodiments of this application separately from a perspective of a functional architecture and a perspective of a product architecture for implementing a function.

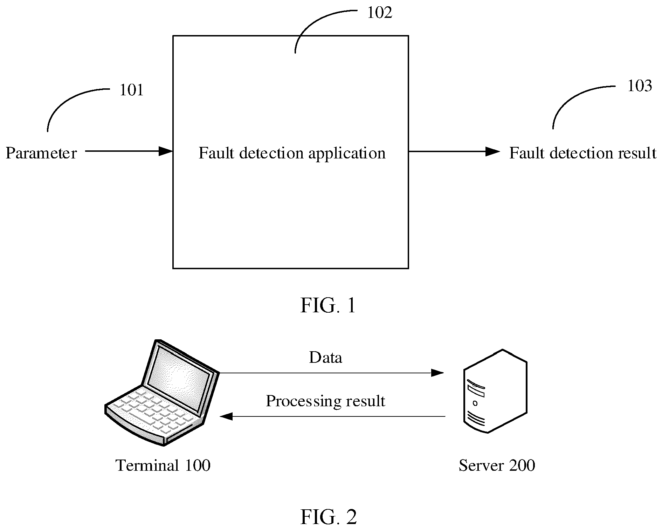

FIG. 1 is a diagram of a functional architecture of a fault detection application according to an embodiment of this application.

In a possible implementation, as shown in FIG. 1, the fault detection application 102 may receive an input parameter 101 (for example, the operation data of the motor) and generate a fault detection result 103 of the operation data of the motor. The fault detection application 102 may be executed (for example) on at least one computer system and includes computer code. When computer code is executed by one or more computers, the computer is enabled to perform the fault detection method described in this specification.

FIG. 2 is a diagram of an entity architecture for running a fault detection application according to an embodiment of this application.

FIG. 2 is a diagram of a system architecture. The system may include a terminal 100 and a server 200. The server 200 may include one or more servers (in FIG. 2, an example in which one server is included is used for description), and the server 200 may provide a fault detection service for one or more terminals.

A fault detection application may be installed on the terminal 100, or a web page related to fault detection may be opened. The application and the web page may provide a fault detection interface. The terminal 100 may receive a related parameter input by the user on the fault detection interface, and send the parameter to the server 200. The server 200 may obtain a processing result based on the received parameter, and return the processing result to the terminal 100.

It should be understood that in some optional implementations, the terminal 100 may alternatively complete an action of obtaining the data processing result based on the received parameter, without cooperation of the server. This is not limited in embodiments of this application.

The following describes a product form of the terminal 100 in FIG. 2.

The terminal 100 in embodiments of this application may be a mobile phone, a tablet computer, a wearable device, a vehicle-mounted device, an augmented reality (augmented reality, AR)/virtual reality (virtual reality, VR) device, a notebook computer, an ultra-mobile personal computer (ultra-mobile personal computer, UMPC), a netbook, a personal digital assistant (personal digital assistant, PDA), or the like. This is not limited in embodiments of this application.

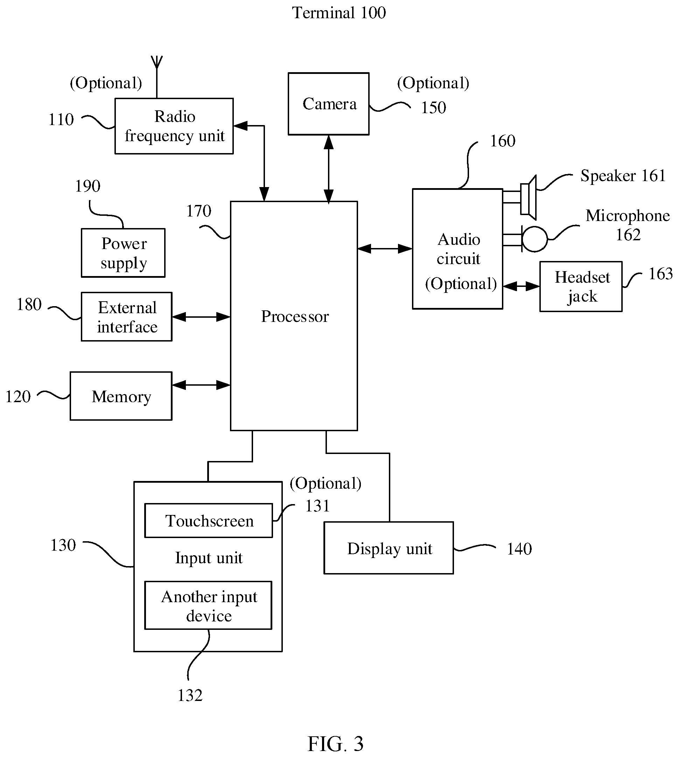

FIG. 3 is a diagram of an optional hardware structure of a terminal 100.

Refer to FIG. 3. The terminal 100 may include components such as a radio frequency unit 110, a memory 120, an input unit 130, a display unit 140, a camera 150 (optional), an audio circuit 160 (optional), a speaker 161 (optional), a microphone 162 (optional), a processor 170, an external interface 180, and a power supply 190. A person skilled in the art may understand that FIG. 3 is merely an example of a terminal or a multi-functional device and does not constitute a limitation on the terminal or the multi-functional device. The terminal or the multi-functional device may include more or fewer components than those shown in the figure, or combine some components, or have different components.

The input unit 130 may be configured to receive input digital or character information, and generate a key signal input related to user setting and function control of the portable multi-functional apparatus. Specifically, the input unit 130 may include a touchscreen 131 (optional) and/or another input device 132. The touchscreen 131 may collect a touch operation performed by a user on or near the touchscreen 131 (for example, an operation performed by the user on or near the touchscreen by using any proper object such as a finger, a joint, or a stylus), and drive a corresponding connection apparatus based on a preset program. The touchscreen may detect a touch operation performed by the user on the touchscreen, convert the touch operation to a touch signal and send the touch signal to the processor 170, and can receive and execute a command sent by the processor 170. The touch signal includes at least touch point coordinate information. The touchscreen 131 may provide an input interface and an output interface between the terminal 100 and the user. In addition, the touchscreen may be implemented in a plurality of types, such as a resistive type, a capacitive type, an infrared ray type, and a surface acoustic wave type. In addition to the touchscreen 131, the input unit 130 may further include the another input device. Specifically, the another input device 132 may include but is not limited to one or more of a physical keyboard, a function button (such as a volume control button 132 or a power on/off button 133), a trackball, a mouse, a joystick, and the like.

The input device 132 may receive input operation data of the motor, and the like.

The display unit 140 may be configured to display information input by the user, information provided for the user, various menus of the terminal 100, an interaction interface, file display, and/or playing of any multimedia file. In embodiments of this application, the display unit 140 may be configured to display an interface of a fault detection application, a fault detection result, and the like.

The memory 120 may be configured to store instructions and data. The memory 120 may mainly include an instruction storage area and a data storage area. The data storage area may store various kinds of data such as a multimedia file and a text; and the instruction storage area may store software units such as an operating system, an application, and instructions required by at least one function, or subsets and extended sets thereof. The memory 120 may further include a non-volatile random access memory, and provide hardware, software, a data resource, and the like in a management and calculation processing device to the processor 170, to support control on software and an application. The memory 120 is further configured to: store a multimedia file, and run a program and store an application.

The processor 170 is a control center of the terminal 100, connects various parts of a whole terminal 100 by using various interfaces and lines, and executes various functions of the terminal 100 and processes data by running or executing the instructions stored in the memory 120 and invoking the data stored in the memory 120, to entirely control the terminal device. Optionally, the processor 170 may include one or more processing units. Preferably, an application processor and a modem processor may be integrated into the processor 170. The application processor mainly processes an operating system, a user interface, an application, and the like. The modem processor mainly processes wireless communication. It can be understood that the modem processor may not be integrated into the processor 170. In some embodiments, the processor and the memory may be implemented on a single chip. In other embodiments, the processor and the memory may be implemented on separate chips. The processor 170 may be further configured to: generate a corresponding operation control signal, and send the operation control signal to a corresponding component in the calculation processing device, and read and process data in software, especially read and process the data and the program in the memory 120, so that functional modules perform corresponding functions, to control a corresponding component to perform an operation as required by an instruction.

The memory 120 may be configured to store software code related to the fault detection method. The processor 170 may perform steps of the fault detection method of the chip, or may schedule other units (for example, the foregoing input unit 130 and the display unit 140) to implement corresponding functions.

The radio frequency unit 110 (optional) may be configured to receive and send a signal in an information receiving and sending process or a call process. For example, after receiving downlink information of a base station, the radio frequency unit 110 sends the downlink information to the processor 170 for processing. In addition, the radio frequency unit 110 sends uplink-related data to the base station. Usually, an RF circuit includes but is not limited to an antenna, at least one amplifier, a transceiver, a coupler, a low noise amplifier (Low Noise Amplifier, LNA), a duplexer, and the like. In addition, the radio frequency unit 110 may further communicate with a network device and another device through wireless communication. The wireless communication may use any communication standard or protocol, including but not limited to a global system for mobile communications (Global System of Mobile communications, GSM), a general packet radio service (General Packet Radio Service, GPRS), code division multiple access (Code Division Multiple Access, CDMA), wideband code division multiple access (Wideband Code Division Multiple Access, WCDMA), long term evolution (Long Term Evolution, LTE), an email, a short message service (Short Messaging Service, SMS), and the like.

In embodiments of this application, the radio frequency unit 110 may send a parameter of the chip to the server 200, and receive a fault detection result sent by the server 200.

It should be understood that the radio frequency unit 110 is optional, and may be replaced with another communication interface, for example, may be a network interface.

The terminal 100 further includes the power supply 190 (such as a battery) for supplying power to various components. Preferably, the power supply may be logically connected to the processor 170 by using a power management system, so that functions such as charging and discharging management and power consumption management are implemented by using the power management system.

The terminal 100 further includes the external interface 180. The external interface may be a standard micro USB interface, or may be a multi-pin connector, and may be configured to connect the terminal 100 to another apparatus for communication, or may be configured to connect to a charger to charge the terminal 100.

Although not shown, the terminal 100 may further include a flash, a wireless fidelity (wireless fidelity, Wi-Fi) module, a Bluetooth module, sensors with different functions, and the like. Details are not described herein. Some or all of the methods described below may be applied to the terminal 100 shown in FIG. 3.

The following describes a product form of the server 200 in FIG. 2.

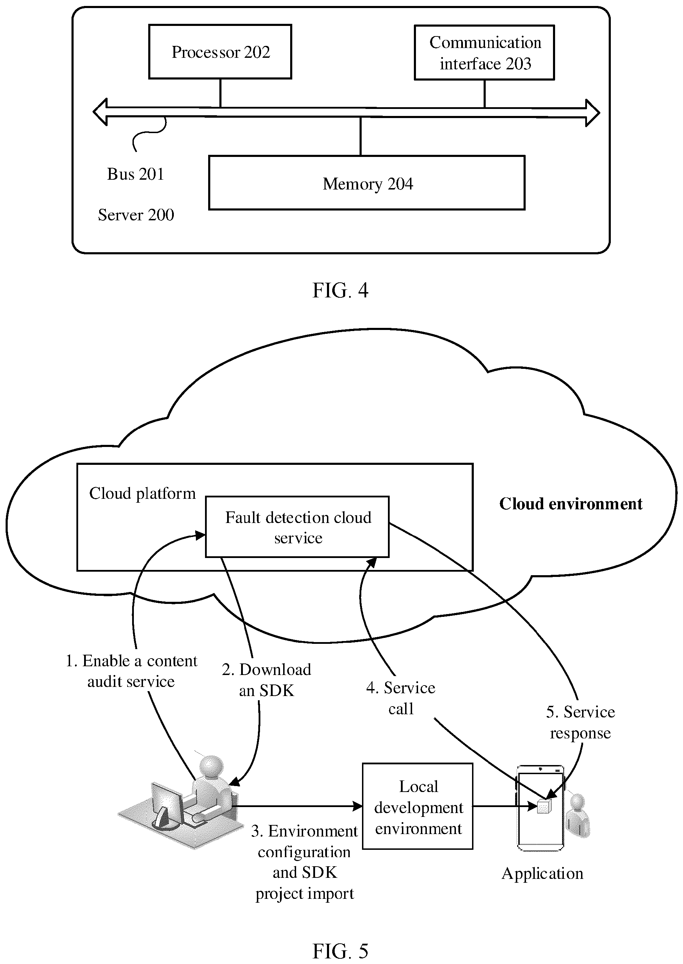

FIG. 4 is a diagram of a structure of a server 200. As shown in FIG. 4, the server 200 includes a bus 201, a processor 202, a communication interface 203, and a memory 204. The processor 202, the memory 204, and the communication interface 203 communicate with each other through the bus 201.

The bus 201 may be a peripheral component interconnect (peripheral component interconnect, PCI) bus, an extended industry standard architecture (extended industry standard architecture, EISA) bus, or the like. Buses may be classified into an address bus, a data bus, a control bus, and the like. For ease of representation, only one bold line is used for representation in FIG. 4, but this does not mean that there is only one bus or only one type of bus.

The processor 202 may be any one or more of processors such as a central processing unit (central processing unit CPU), a graphics processing unit (graphics processing unit, GPU), a microprocessor (microprocessor, MP), or a digital signal processor (digital signal processor DSP).

The memory 204 may include a volatile memory (volatile memory), for example, a random access memory (random access memory, RAM). The memory 204 may further include a non-volatile memory (non-volatile memory), for example, a read-only memory (read-only memory, ROM), a flash memory, a mechanical hard disk drive (hard disk drive, HDD), or a solid-state drive (solid-state drive, SSD).

The memory 204 may be configured to store software code related to the fault detection method. The processor 202 may perform steps of the fault detection method of the chip, or may schedule other units to implement corresponding functions.

It should be understood that the terminal 100 and the server 200 may be central or distributed devices. Processors (for example, the processor 170 and the processor 202) in the terminal 100 and the server 200 may be a hardware circuit (for example, an application-specific integrated circuit (application specific integrated circuit, ASIC), a field programmable gate array (field-programmable gate array, FPGA), a general-purpose processor, a digital signal processor (digital signal processor, DSP), a microprocessor, or a microcontroller), or a combination of these hardware circuits. For example, the processor may be a hardware system that has an instruction execution function, such as a CPU or a DSP, or may be a hardware system that does not have an instruction execution function, such as an ASIC or an FPGA, or may be a combination of the foregoing hardware system that does not have an instruction execution function and the foregoing hardware system that has an instruction execution function.

2. Fault detection cloud service provided by a server

In a possible implementation, the server may provide a fault detection service for a terminal side through an application programming interface (application programming interface, API).

The terminal device may send a related parameter (for example, the operation data of the motor) to the server through an API provided by the cloud. The server may obtain a processing result based on the received parameter, and return the processing result (for example, a fault detection result of the operation data of the motor) to the terminal.

For descriptions about the terminal and the server, refer to descriptions in the foregoing embodiments. Details are not described herein again.

FIG. 5 shows a process of using a fault detection cloud service provided by a cloud platform.

1. Enable and purchase a content audit service.

2. The user may download a software development kit (software development kit, SDK) corresponding to the content audit service. Usually, the cloud platform provides SDKs of a plurality development versions for selection by the user according to a development environment requirement, for example, a Java-version SDK, a Python-version SDK, a PHP-version SDK, and an Android-version SDK.

3. The user downloads an SDK of a corresponding version locally as required, imports an SDK project to a local development environment, and configures and debugs the SDK project in the local development environment. The local development environment may further be used for development of other functions, to form an application that integrates fault detection capabilities.

4. During use of the fault detection application, when fault detection is required, an API call for fault detection may be triggered. When an application triggers a fault detection function, an API request is initiated to a running instance of a fault detection service in a cloud environment. The API request carries the operation data of the motor, and the running instance in the cloud environment processes the operation data of the motor, to obtain the fault detection result.

5. The cloud environment returns the fault detection result to the application, thereby completing one fault detection service call.

For descriptions about the terminal and the server, refer to descriptions in the foregoing embodiments. Details are not described herein again.

Embodiments of this application relate to much knowledge about fault detection. To better understand solutions in embodiments of this application, the following first describes related terms and concepts that may be used in embodiments of this application. It should be understood that related concept explanation may be limited due to specific situations of embodiments of this application, but this does not mean that this application is limited to only these specific situations, and specific situations of different embodiments may differ. This is not specifically limited herein.

(1) Fourier decomposition

The Fourier decomposition may also be referred to as a Fourier transform, and can express a specific function as a trigonometric function (sine function and/or cosine function) or a linear combination of integrals thereof. In different research fields, the Fourier transform has many different variants, such as a continuous Fourier transform and a discrete Fourier transform. A core of the Fourier transform is transformation from time domain to frequency domain, and such transformation is implemented by a group of special orthogonal bases.

(2) Harmonic and fundamental

The harmonic is various orders of components that are obtained by performing Fourier series decomposition on a periodic non-sinusoidal alternating quantity and that are greater than an integer multiple of a fundamental frequency, and is usually referred to as a higher-order harmonic. The fundamental is a component whose frequency is the same as a utility frequency (50 Hz).

(3) Motor

The motor is a device that converts electrical energy into mechanical energy. The motor generates a rotating magnetic field by using an energized coil (namely, a stator winding), which acts on a rotor (for example, a squirrel-cage closed aluminum frame) to produce a magnetoelectric force rotational torque. Motors are classified into direct-current motors and alternating-current motors based on different power supplies. Most motors in a power system are alternating-current motors, which may be synchronous motors or asynchronous motors (in the motor, a stator magnetic field rotating speed is not synchronous with a rotor rotating speed). The motor mainly includes a stator and the rotor. A direction of force acting on an energized conducting wire in a magnetic field is related to a direction of a current and a direction of a magnetic induction line (magnetic field direction). The motor works on a principle that the magnetic field acts on the current, causing the motor to rotate.

(4) Alternating-current motor

The "alternating-current motor" is a machine configured to implement transformation between mechanical energy and alternating-current electrical energy. Due to significant development of an alternating-current power system, the alternating-current motor has become the most commonly used motor. Compared with a direct-current motor, the alternating-current motor has no commutator (see commutation of the direct-current motor). Therefore, the alternating-current motor is simple in structure, convenient to manufacture, firm, and easy to be made into a motor with a high speed, a high voltage, a large current, and a large capacity.

(5) Three-phase current

The three-phase current is a current that passes through three wires, where each wire serves as a loop of the other two wires, and a phase difference between three components of the three-phase current is one-third of a cycle or a 120° phase angle.

(6) Stator

The stator is a static part of a motor. The stator includes three parts: a stator iron core, a stator winding, and a frame. A function of the stator is to produce an alternating current, while a function of a rotor is to form a rotating magnetic field.

(7) Peak-to-peak value

The peak-to-peak value is a difference between the highest and lowest signal values in one cycle, that is, a range between maximum and minimum signal values. The peak-to-peak value describes a magnitude of a variation range of a signal value.

A motor is the most common device for driving various machinery in a production process. The motor is widely used in industrial production, transportation, infrastructure construction, agricultural development, and daily life. Power consumption of the motor accounts for more than 80% of total production power consumption. As a kind of electrical device that provides power for a plurality of industries, the motor has many potential fault factors, and a shutdown and production interruption caused by a fault brings a great economic loss. If the fault of the motor can be discovered in time, and repairing and maintenance can be performed in an early stage of the fault of the motor, a service life of the motor can be extended effectively, and reliability and stability of an entire production system can be improved.

To ensure stable operation of the motor, various sensors are set to monitor various parameter values of the motor. If some parameter values exceed preset values of a relay, the relay will give an alarm, and stop operation of the motor by cutting off a control loop of the motor when necessary, to prevent further escalation of a production accident.

On the surface, protection settings of the motor seem to be perfect, but in actual operation, the relay gives the alarm only when the motor is faulty. However, if the motor is suddenly powered off or stops operating, a great loss will be caused.

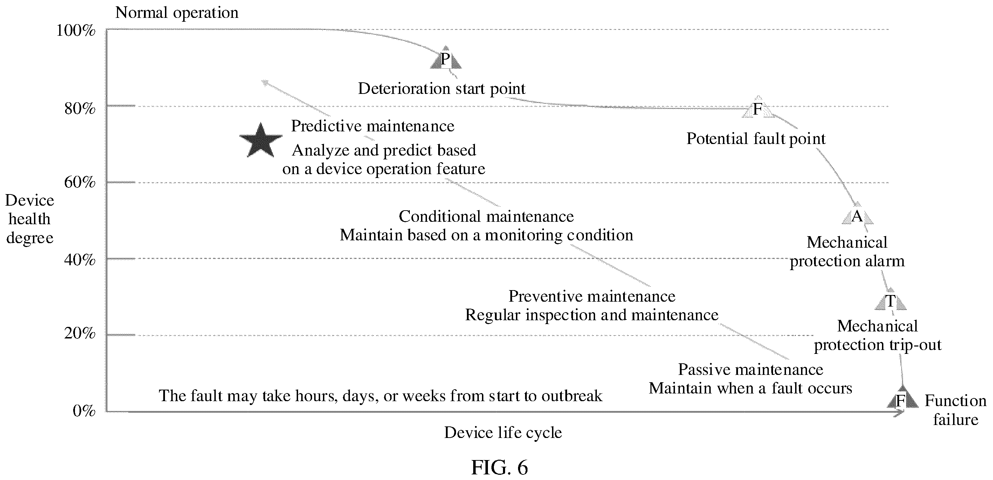

As shown in FIG. 6, such a manner can only be used to detect a fault after a point A, that is, a point at which a functional fault occurs. When the point A is reached, the device completely fails. However, a part between a point P, a point F, and the point A, namely, a deterioration start point, a potential fault occurrence point, and the functional fault point, cannot be found. It should be noted that, that a potential fault exists in the motor does not mean that the fault has occurred in the motor, but is a deterioration phenomenon that appears before the fault occurs. Therefore, a method for determining a degree of the potential fault existing in the motor is urgently needed, and the degree of the potential fault may represent a deterioration degree of the motor.

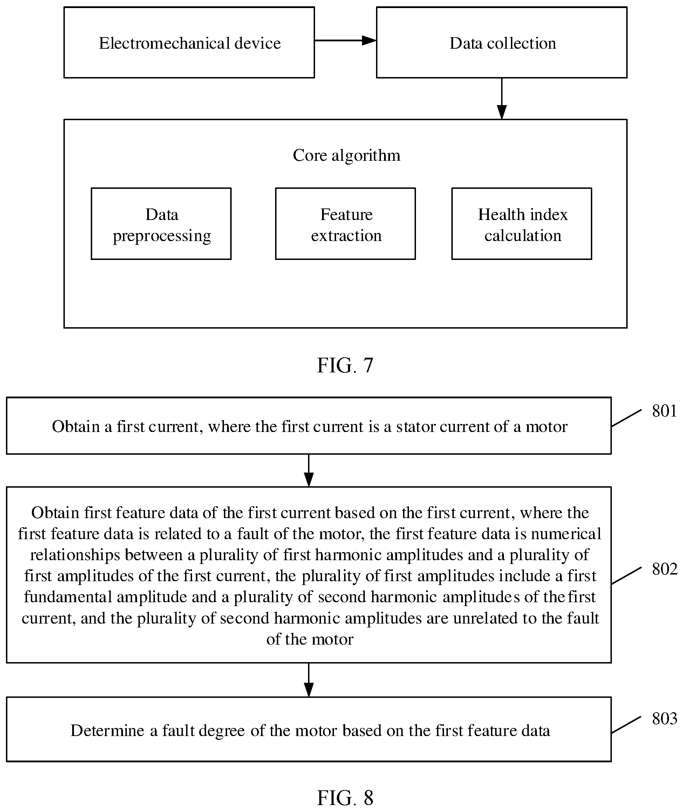

The following describes a diagram of an application architecture according to an embodiment of this application with reference to the application scenarios of fault detection of the motor. FIG. 7 is a diagram of an architecture using an industrial scenario as an example. A stator current signal collector may be installed on an electric control cabinet side of the motor to collect and report data. Then, an edge side (the edge side is optional and may be, for example, an edge gateway) aggregates and reports the data. A central side (for example, a server) may perform the fault detection method in embodiments of this application based on the reported data, and output a fault detection result.

FIG. 8 is a schematic flowchart of an embodiment of a fault detection method according to an embodiment of this application. The fault detection method includes the following steps.

801: Obtain a first current, where the first current is a stator current of a motor.

In a possible implementation, to detect a fault of the motor, related operating parameters during operation of the motor may be analyzed. In the operating parameters of the motor, the stator current is a relatively sensitive state parameter inside the motor, and is easily obtained as a non-intrusive sensing signal and may be directly collected in a power distribution cabinet. In this embodiment of this application, a harmonic component of the stator current may be analyzed to determine a fault degree of the motor.

In a possible implementation, a sensor configured to collect the stator current on the motor may be disposed, for example, a stator current signal collector. The sensor may collect a stator current of a stator on the motor. For example, the stator current signal collector may be installed on an electric control cabinet side of the motor.

The stator current of the motor stator may be three-phase electricity, and the stator current may be one or more phases of currents in the three-phase electricity. For example, the three-phase electricity may include a first-phase current, a second-phase current, and a third-phase current, which respectively correspond to a U phase, a V phase, and a W phase in the three-phase electricity.

The sensor may collect the stator current at a specific frequency. To ensure subsequent fault analysis precision, a sampling frequency may be, for example, at least 1 kHz.

In some cases, a current value part or a current value abnormality (an abnormal state such as an obvious value jump exists) occurs in the one or more phases of the three-phase electricity. To improve accuracy of the collected stator current, for a missing part or an abnormal part of a specific-phase current, corresponding current values of another phase or other two phases may be used for supplement (because currents of different phases of the three-phase electricity are only different in phase but have a same amplitude under normal circumstances). For example, if a plurality of phases of currents are collected, signal preprocessing may be performed based on a correlation between the currents. For example, amplitudes of aligned phases in a plurality of phases (for example, two or three phases) of the three-phase electricity may be fused as the first current.

For example, the fusion may be splicing or averaging of amplitudes of different phases.

For example, phase alignment may be performed on the three phases of currents, and weighted averaging is performed after the alignment. That is, current = $\sum c_{\{1\text{-}3\}} w\_i * c\_i / \sum c_{\{1\text{-}3\}} w\_i$, where current may be the first current, $c_{\{1\text{-}3\}}$ represents currents of all the phases, $\sum$ represents summation, and $w\_i$ represents a weight. If it is determined that a current value is a non-abnormal value, the weight is 1. If a current value is an abnormal value, the weight is 0. In addition, other preprocessing may be further performed on an original signal of a collected current. For example, for missing data, a value that appears most frequently in a data set may be selected to fill corresponding missing data. For repeated data processing, a first piece of data may be extracted and considered as a new class. A next piece of data is analyzed, and an attribute of the next piece of data is compared with that of an existing class. When differences between currents and voltages are less than a specified threshold, the data is allocated to a class that matches the data, and an attribute of the class is recalculated. If the attribute of the data does not match all currently existing classes, a new class is created and a new attribute is created. Preceding two steps are repeated until each record is scanned and calculated, and is correctly placed in a corresponding class.

For abnormal data, a normal range band may be defined. If voltage or current data is not within the band, the voltage or current data is considered as abnormal data and is directly removed.

In addition, due to interference of internal noise, a collected original signal may have noise, and denoising processing may be performed on the original signal. For example, a wavelet threshold denoising method may be used. First, wavelet decomposition is performed on the original signal, a proper wavelet coefficient threshold is selected, and the threshold is compared with a high-frequency wavelet coefficient at each decomposition scale. If the wavelet coefficient is greater than a threshold, the wavelet coefficient is reserved; or otherwise, proper threshold processing is performed. Inverse wavelet transform is performed on a wavelet coefficient obtained through threshold processing, to obtain a denoised reconstructed signal.

In a possible implementation, a first time period may be a continuous time period or a plurality of moments in a continuous time period, or the first time period may be a discontinuous time period or a plurality of moments in a discontinuous time period. This is not limited herein. For example, the first current may be a current instantaneous value at each of a plurality of moments in a time period.

802: Obtain first feature data of the first current based on the first current, where the first feature data is related to the fault of the motor, the first feature data is numerical relationships between a plurality of first harmonic amplitudes and a plurality of first amplitudes of the first current, the plurality of first amplitudes include a first fundamental amplitude and a plurality of second harmonic amplitudes of the first current, and the plurality of second harmonic amplitudes are unrelated to the fault of the motor.

803: Determine the fault degree of the motor based on the first feature data.

When a potential fault occurs in the motor, an air gap of a magnetic field of the motor is uneven. The foregoing phenomenon is directly reflected in the stator current. For example, there may be a significant harmonic component in the current, or instability in phase value fluctuations. **In** this application, feature data in a signal (stator current) caused by the potential fault of the motor is extracted. The feature data reflects an abnormal component in the stator current, and a degree of the potential fault existing in the motor may be determined based on the feature data.

The abnormal component in the signal (stator current) caused by the potential fault of the motor may be a harmonic component or a phase value fluctuation (variation feature), which is separately described in the following.

    1. The feature data is the harmonic component in the stator current.

The harmonic component may also be referred to as a harmonic current. The harmonic current is a general term of sinusoidal components whose frequencies are integer multiples of an original periodic current frequency when a non-sinusoidal periodic current function is expanded according to a Fourier series.

In a possible implementation, Fourier decomposition may be performed on the first current to obtain a fundamental and a plurality of harmonics of the first current. The potential fault of the motor may be reflected in one or more of the plurality of harmonics. In other words, the one or more of the plurality of harmonics are related to the potential fault existing in the motor, and the degree of the potential fault existing in the motor may be directly reflected in the one or more of the plurality of harmonics.

Not all harmonics are related to the potential fault existing in the motor, and some harmonics also exist when the motor operates normally (for example, due to a working condition of the motor). To analyze the degree of the potential fault existing in the motor, harmonics that are in the plurality of harmonics and that are related to the potential fault existing in the motor may be identified.

After Fourier decomposition is performed on the first current, frequencies of harmonics related to potential faults existing at locations of different structures on the motor may be different. For example, a potential fault existing in a bearing of the motor may cause an increase in an amplitude of a harmonic at 60 Hz. Therefore, an amplitude of a harmonic of a harmonic frequency corresponding to each structure of the motor may be analyzed (optionally, amplitudes of all the harmonics may be analyzed). If the amplitude meets a preset condition (which is, for example, that the value is greater than a threshold or another condition), it may be considered that the amplitude is an amplitude of a harmonic related to the potential fault of the motor.

However, due to factors such as a motor operating environment, some harmonic amplitudes may meet the foregoing preset condition, but this is not caused by the potential fault of the motor, but caused by the motor operating environment, which leads to a misjudgment. To resolve this problem, in this embodiment of this application, a non-noise harmonic component can be accurately extracted by using a harmonic product spectrum. A principle is as follows: Noise usually generates only a single harmonic. In addition to generating harmonics at a point of a fault frequency, the fault further generates harmonic components at a multiplied-frequency position of the fault frequency. Through fusion (for example, a product, as described in Formula (1)), a harmonic feature related to the potential fault of the motor may be amplified and noise can be removed.

$$H(\omega) = F(\omega) \cdot F(2\omega) \cdots F(K\omega) = \prod_{k=1}^{K} F(k\omega) \quad (1)$$

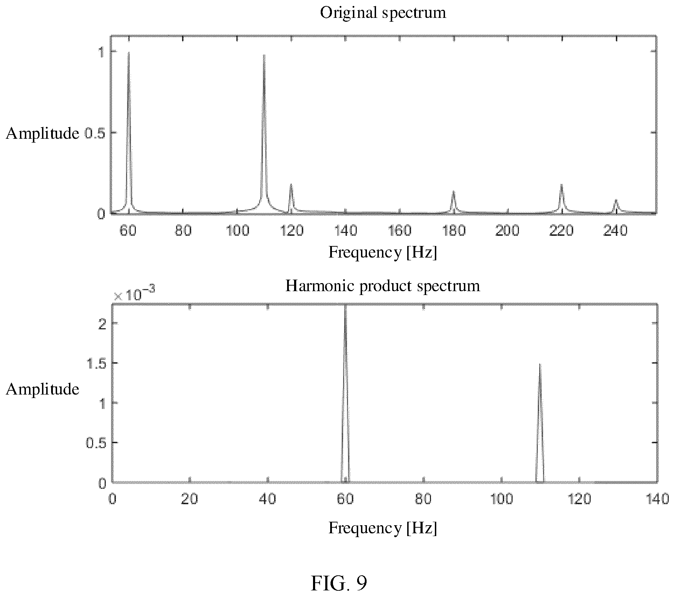

For example, a principle of a harmonic product spectrum may be shown in FIG. 9, and 60 Hz and 110 Hz are frequencies of harmonics related to the potential fault.

In other words, after the first current is processed, feature data of the first current may be obtained. The feature data includes an amplitude of a fundamental (for example, the first fundamental amplitude in this embodiment of this application) and amplitudes of a plurality of harmonics (for example, the plurality of first harmonic amplitudes in this embodiment of this application) of the first current. The plurality of first harmonic amplitudes in the plurality of first harmonic amplitudes are amplitudes of harmonics related to the potential fault existing in the motor. In addition, a fusion result (for example, the fusion result may be obtained through a product operation, a neural network, or the like) of each of the plurality of first harmonic amplitudes and a plurality of corresponding fourth harmonic amplitudes meets a preset condition, or each of the plurality of first harmonic amplitudes and each of the plurality of corresponding fourth harmonic amplitudes meet the preset condition. Each fourth harmonic amplitude is an amplitude of a harmonic of a multiplied frequency of a harmonic frequency corresponding to the first harmonic amplitude, and the preset condition may be that a value is greater than a threshold. Through the foregoing manner, a misjudgment caused by a factor such as a motor operating environment can be eliminated, and a harmonic related to the potential fault of the motor can be accurately identified.

The fusion result (for example, the fusion result may be obtained through a product operation, a neural network, or the like) of each of the plurality of first harmonic amplitudes and the plurality of corresponding fourth harmonic amplitudes meets the preset condition, and each fourth harmonic amplitude is an amplitude of a harmonic of a multiplied frequency of a harmonic frequency corresponding to the first harmonic amplitude. Through the foregoing manner, a misjudgment caused by a factor such as a motor operating environment can be eliminated, and a harmonic related to the potential fault of the motor can be accurately identified.

In addition, frequencies of harmonics related to potential faults existing at locations of different structures on the motor are different, and there is a correspondence (between a structure of the motor and a harmonic frequency). Different motors have different motor structures, and correspondences between structures and harmonic frequencies may also be different. In a conventional technology, for different motors, a correspondence between a structure of the motor and a harmonic frequency may be used as prior information. Whether a harmonic frequency is abnormal is analyzed to determine which structures of the motor are abnormal. However, even if a value of a corresponding frequency that does not belong to the motor structure in the correspondence is greater than a specific threshold, it is considered that the frequency is not a harmonic frequency corresponding to a faulty component. In other words, the conventional technology relies on prior information for fault detection. In this embodiment of this application, faulty components of the motor do not need to be located, and only frequencies of harmonics related to the fault need to be determined. Therefore, by using the foregoing method for determining a value of the harmonic of the multiplied frequency, faulty components can be accurately determined without relying on prior information.

In the foregoing manner, only the harmonic related to the potential fault of the motor can be identified, and structures of the motor that have potential faults can be located. To quantize the degree of the potential fault existing in the motor, the amplitude of the harmonic related to the potential fault may be analyzed.

In a possible implementation, the feature data may include a plurality of first amplitudes, and the plurality of first amplitudes include a first fundamental amplitude and a plurality of second harmonic amplitudes (optionally, the plurality of first amplitudes may further include the plurality of first harmonic amplitudes) of the first current. The second harmonic amplitudes may be related to noise such as a working condition for operation of the motor, and are not caused by the fault of the motor. The plurality of first harmonic amplitudes in the plurality of first harmonic amplitudes are related to the potential fault of the motor.

The fusion result (for example, the first fusion result in this embodiment of this application) of the plurality of first harmonic amplitudes related to the potential fault of the motor may represent energy related to the potential fault of the motor, while the fusion result (for example, the second fusion result in this embodiment of this application) of the plurality of amplitudes may represent total energy. Therefore, the numerical relationships between the plurality of first harmonic amplitudes and the plurality of first amplitudes are a numerical relationship between the energy related to the potential fault of the motor and the total energy, which can represent the degree of the potential fault existing in the motor.

For different motors or a same motor in different operating environments such as different working conditions, fault-related harmonic components in a stator current may differ due to noise such as a working condition. In other words, even if fault degrees of the motor are the same, magnitudes of fault-related harmonics may be different for different motors or different working conditions. To eliminate impact of different working conditions or different motors on a magnitude of a harmonic current, in this application, numerical relationships between an amplitude of a fault-related harmonic current, a fundamental obtained by decomposing the stator current, and a harmonic unrelated to the fault are used as a feature representation to determine the fault degree, so that an accurate fault degree can be determined by eliminating impact of different working conditions or different motors on the magnitude of the harmonic current.

In a possible implementation, the numerical relationship may be a first difference degree between the first fusion result and the second fusion result. For example, the first fusion result or the second fusion result is obtained through accumulation, and the first difference degree may be a ratio.

In a possible implementation, amplitudes of fundamentals or harmonics of different motors or a same motor in different operating environments may be different. The degree of the potential fault existing in the motor cannot be accurately described by using only feature data of the motor during a specific time period. For example, for a motor A and a motor B, noise in an operating environment in which the motor A is located is relatively large. Therefore, even if an amplitude of a harmonic related to a potential fault in harmonics is relatively large (that is, a degree of the potential fault is relatively high), when the degree of the potential fault is relatively large, an incorrect conclusion that the degree of the potential fault is relatively small may be obtained because a difference between the amplitude of the harmonic related to the potential fault and total energy is relatively large.

In this application, to adapt to different motors or different motor operating environments, feature data of the motor during normal operation or in a historical operating time period may be used as a baseline, and the degree of the potential fault of the motor is determined by comparing real-time feature data of the motor with the baseline, so that difference interference of different motors or a same motor in different operating environments can be reduced.

In a possible implementation, the plurality of first harmonic amplitudes are amplitudes of a plurality of first-frequency harmonics; and the degree of the potential fault existing in the motor may be determined based on a second difference degree between a first numerical relationship and a second numerical relationship. The first numerical relationship is the numerical relationships between the plurality of first harmonic amplitudes and the plurality of first amplitudes. The second numerical relationship is numerical relationships between a plurality of third harmonic amplitudes and a plurality of second amplitudes of a second current. The plurality of second amplitudes include a fundamental amplitude and a plurality of harmonic amplitudes of the second current. The second current is the stator current of the motor in the absence of fault or in a second time period. The plurality of third harmonic amplitudes are amplitudes of the plurality of first-frequency harmonics in the plurality of harmonic amplitudes. The second time period is a time period before the first time period.

For example, a ratio of corresponding harmonic energy in the harmonic product spectrum to total signal energy may be calculated. A calculation method is as follows: hocc = \sum harm(i) divided by \sum amp(i), where \sum represents accumulation, harm(i) represents an amplitude of a corresponding harmonic in the spectrum, and amp(i) represents an amplitude of each spectral line in the spectrum. An average value of hocc in n segments of data at an initial moment may be used as a baseline. A difference between harmonic occupancy rates is calculated, and is used as a "distance": dis_hocc = hocc - hocc_base.

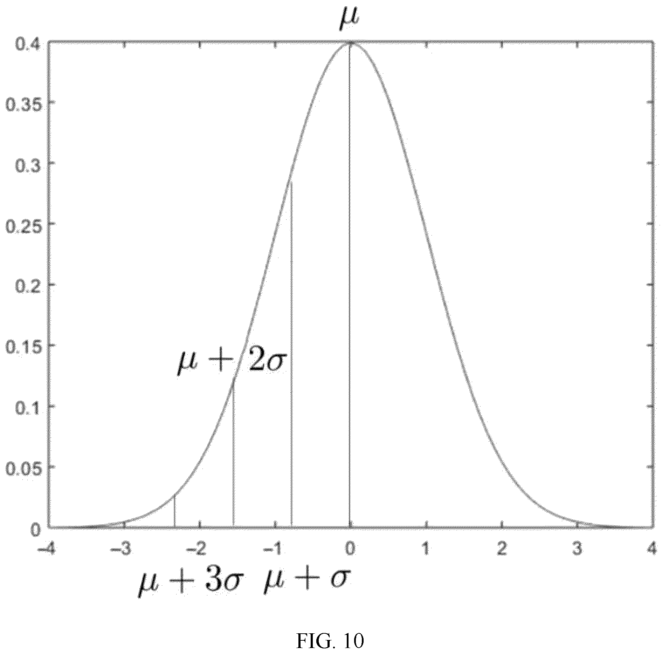

Optionally, refer to FIG. 10. Distances between n segments of normal stator current signals (or historical stator current signals) may be used for normal distribution fitting. An average value and a standard deviation are calculated, and an interval of dis_hocc within normal signal distribution is calculated, to determine a fault severity. If dis_hocc is beyond a 1-sigma interval, a minor fault is determined. If dis_hocc is beyond a 2-sigma interval, a moderate fault is determined. If dis_hocc is beyond a 3-sigma interval, a severe fault is determined.

2. The feature data is a variation feature of a phase value of the stator current in time domain.

In a possible implementation, the feature data includes a first variation feature, in time domain, of a first phase value corresponding to the first current, and the phase value is a phase in a complex signal obtained by decomposing the first current. Optionally, the first variation feature may be related to a variation amplitude of the first phase value in time domain. For example, the variation amplitude may be represented by an average value of peak-to-peak values.

When a potential fault occurs in a motor drive system, an air gap of a magnetic field of the motor is uneven. The foregoing phenomenon is directly reflected in the stator current. That is, a phase variation occurs in a stationary part of the stator current (for example, a peak-to-peak value of a phase fluctuates).

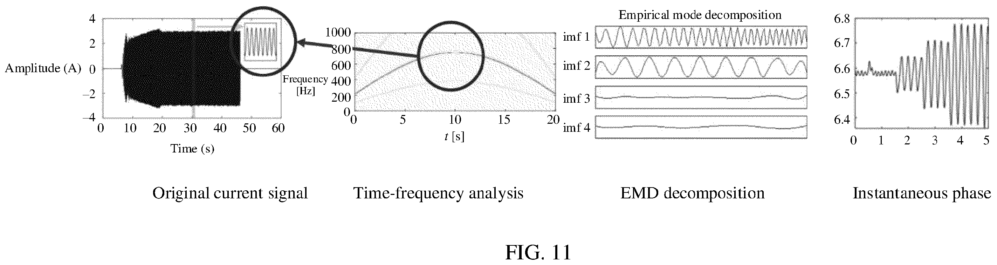

To extract the stationary part in the stator current, a stationary component in the stator current signal may be separated based on a signal preprocessing method, and then feature calculation and extraction are performed. Specific steps may be, for example, as follows: First, signal screening is performed. Short-term Fourier transform is performed on a signal, to see whether a fluctuation of a dominant frequency component exceeds a specific threshold (for example, 5%). If the fluctuation does not exceed the threshold, a next step is performed. Then, signal decomposition is performed. Empirical mode decomposition (empirical mode decomposition, EMD) or ensemble empirical mode decomposition (ensemble empirical mode decomposition, EEMD) is performed on the signal, to extract the stationary part, which, for example, may be a first intrinsic mode function (intrinsic mode function, IMF) component. For details, refer to FIG. 11.

The extracted stationary part is processed to obtain an instantaneous phase of the first current at each moment, and then a variation amplitude of the instantaneous phase of the signal (that is, the first current) is calculated.

In a possible implementation, determining the fault degree of the motor based on the first variation feature includes: determining the fault degree of the motor based on a difference degree between the first variation feature and a second variation feature. The second variation feature is numerical relationships between the plurality of third harmonic amplitudes and the plurality of second amplitudes of the second current. The plurality of second amplitudes include the second variation feature of the first phase value corresponding to the second current in time domain. The second current is the stator current of the motor in the absence of fault or in the second time period, and the second time period is a time period before the first time period.

For example, an average value (for example, an average value of peak-to-peak values) of n segments of data at an initial moment may be used as a baseline. A difference between a present value and a baseline value is calculated, and is used as a "distance", to obtain: dis_fi = fi - fi_base.

In a possible implementation, the distance dis_hocc (for example, the difference degree between the first variation feature and the second variation feature, and the second difference degree between the first numerical relationship and the second numerical relationship described above) that may be obtained in the foregoing manner may be used to determine the degree of the potential fault.

For example, distances between n segments of normal signals or historical signals may be used for normal distribution fitting. An average value and a standard deviation are calculated, and an interval of dis_hocc within normal signal distribution is calculated, to determine a fault severity. If dis_hocc is beyond a 1-sigma interval, a minor fault is determined. If dis_hocc is beyond a 2-sigma interval, a moderate fault is determined. If dis_hocc is beyond a 3-sigma interval, a severe fault is determined.

In a possible implementation, a degree of the existing potential fault may be represented by a potential fault level, for example, severe, moderate, or minor.

In a possible implementation, a degree of the existing potential fault may be represented by a potential fault score, for example, a value between 0 and 100.

In a possible implementation, a degree of the existing potential fault may be represented by information about comparison between the degree of the potential fault of the electrode and a degree of a potential fault of another motor, for example, rankings of potential fault degrees of the motor.

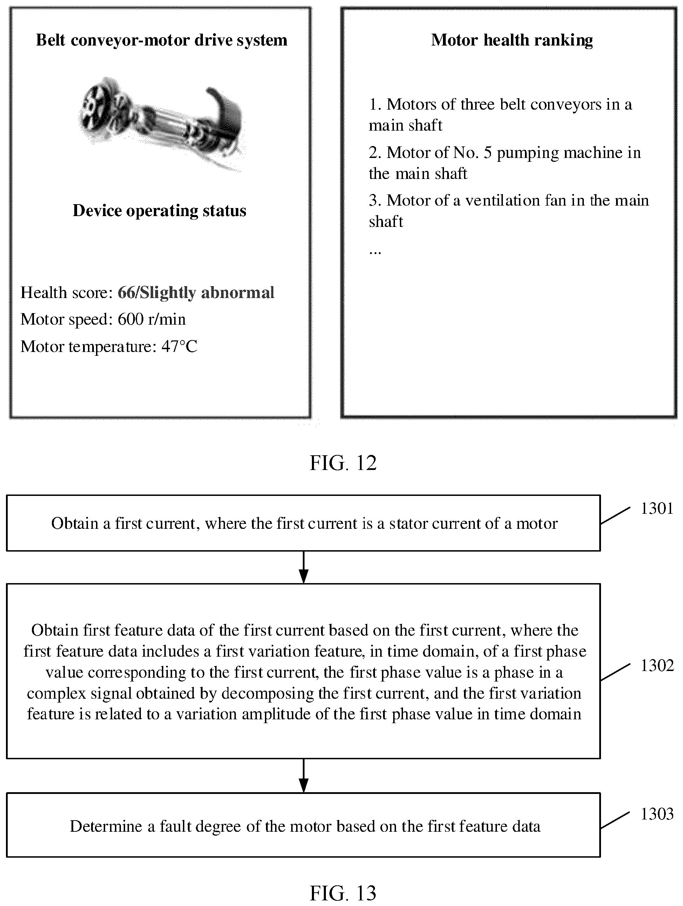

After the degree of the potential fault is obtained, the degree of the potential fault of the motor may be pushed in a manner such as using an app, to the user, who, for example, may be corresponding operation and maintenance personnel, as shown in FIG. 12.

FIG. 13 is a schematic flowchart of a fault detection method according to an embodiment of this application. As shown in FIG. 13, the fault detection method provided in this application includes the following steps.

1301: Obtain a first current, where the first current is a stator current of a motor.

For specific descriptions of step 1301, refer to descriptions of step 801 in the foregoing embodiment. Details are not described herein again.

1302: Obtain first feature data of the first current based on the first current, where the first feature data includes a first variation feature, in time domain, of a first phase value corresponding to the first current, the first phase value is a phase in a complex signal obtained by decomposing the first current, and the first variation feature is related to a variation amplitude of the first phase value in time domain.

1303: Determine a fault degree of the motor based on the first feature data.

For specific descriptions of step 1302 and step 1303, refer to descriptions of step 802 and step 803 in the foregoing embodiment. Details are not described herein again.

In a possible implementation, the first current is a stator current of the motor in a first time period, and the method further includes: obtaining a second current, where the second current is a stator current of the motor during normal operation or in a second time period, and the second time period is a time period before the first time period.

Determining the fault degree of the motor based on the first feature data includes:

obtaining second feature data of the second current based on the second current, where the second feature data and the first feature data are data of a same type; and
determining the fault degree of the motor based on a difference between the first feature data and the second feature data.

In a possible implementation, the second feature data includes a second variation feature, in time domain, of a second phase value corresponding to the second current, the second phase value is a phase in a complex signal obtained by decomposing the second current, and the second variation feature is related to a variation amplitude of the second phase value in time domain.

In a possible implementation, the existing fault degree is represented by a fault level, a fault score, or information about comparison between the fault degree of the electrode and a fault degree of another motor.

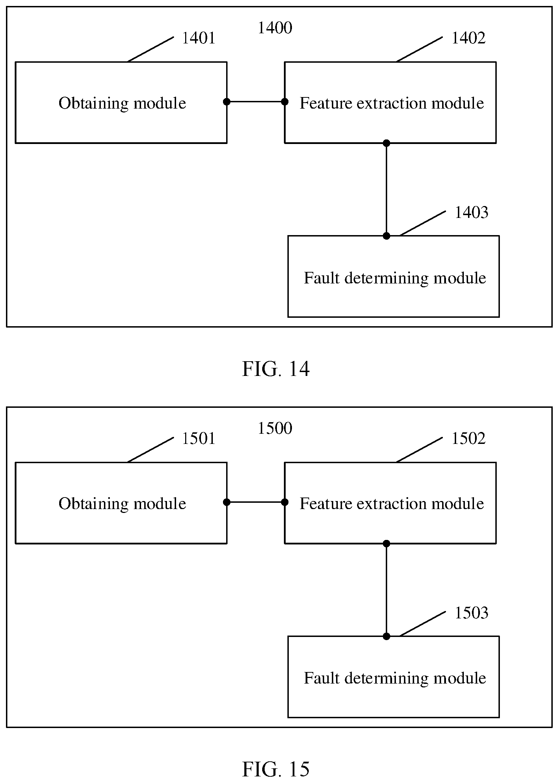

FIG. 14 is a diagram of a structure of a fault detection apparatus according to an embodiment of this application. As shown in FIG. 14, a fault detection apparatus 1400 provided in this application includes an obtaining module 1401, a feature extraction module 1402, and a fault determining module 1403.

The obtaining module 1401 is configured to obtain a first current. The first current is a stator current of a motor.

For specific descriptions of the obtaining module 1401, refer to descriptions of step 801 in the foregoing embodiment. Details are not described herein again.

The feature extraction module 1402 is configured to obtain first feature data of the first current based on the first current. The first feature data is related to a fault of the motor, the first feature data is numerical relationships between a plurality of first harmonic amplitudes and a plurality of first amplitudes of the first current, the plurality of first amplitudes include a first fundamental amplitude and a plurality of second harmonic amplitudes of the first current, and the plurality of second harmonic amplitudes are unrelated to the fault of the motor.

For specific descriptions of the feature extraction module 1402, refer to descriptions of step 802 in the foregoing embodiment. Details are not described herein again.

The fault determining module 1403 is configured to determine a fault degree of the motor based on the first feature data.

For specific descriptions of the fault determining module 1403, refer to descriptions of step 803 in the foregoing embodiment. Details are not described herein again.

In a possible implementation, the first current is a stator current of the motor in a first time period, and the obtaining module is further configured to:
obtain a second current, where the second current is a stator current of the motor during normal operation or in a second time period, and the second time period is a time period before the first time period.

The feature extraction module is further configured to:
obtain second feature data of the second current based on the second current, where the second feature data and the first feature data are data of a same type.

The fault determining module is specifically configured to:

determine the fault degree of the motor based on a difference between the first feature data and the second feature data.

In a possible implementation, the numerical relationships between the plurality of first harmonic amplitudes and the plurality of first amplitudes include:

a first difference degree between a first fusion result and a second fusion result, where the first fusion result is a fusion result of the plurality of first harmonic amplitudes, and the second fusion result is a fusion result of the plurality of first amplitudes.

**In** a possible implementation, the plurality of first harmonic amplitudes are amplitudes of a plurality of first-frequency harmonics in the first current.

The second feature data is numerical relationships between a plurality of third harmonic amplitudes and a plurality of second amplitudes of the second current. The plurality of second amplitudes include a fundamental amplitude and a plurality of harmonic amplitudes of the second current. The second current is the stator current of the motor in the absence of fault or in the second time period. The plurality of third harmonic amplitudes are amplitudes of the plurality of first-frequency harmonics in the plurality of second amplitudes.

**In** a possible implementation, each of the plurality of first harmonic amplitudes and each of a plurality of corresponding fourth harmonic amplitudes are within a preset numerical range, and each fourth harmonic amplitude is an amplitude of a harmonic of a multiplied frequency of a harmonic frequency corresponding to the first harmonic amplitude; or

a fusion result of the plurality of first harmonic amplitudes and the plurality of corresponding fourth harmonic amplitudes is within a preset value range.

In a possible implementation, the existing fault degree is represented by a fault level, a fault score, or information about comparison between the fault degree of the electrode and a fault degree of another motor.

FIG. 15 is a diagram of a structure of a fault detection apparatus according to an embodiment of this application. As shown in FIG. 15, a fault detection apparatus 1500 provided in this application includes an obtaining module 1501, a feature extraction module 1502, and a fault determining module 1503.

The obtaining module 1501 is configured to obtain a first current. The first current is a stator current of a motor.

For specific descriptions of the fault determining module 1501, refer to descriptions of step 1301 in the foregoing embodiment. Details are not described herein again.

The feature extraction module 1502 is configured to obtain first feature data of the first current based on the first current. The first feature data includes a first variation feature, in time domain, of a first phase value corresponding to the first current, the first phase value is a phase in a complex signal obtained by decomposing the first current, and the first variation feature is related to a variation amplitude of the first phase value in time domain.

For specific descriptions of the fault determining module 1502, refer to descriptions of step 1302 in the foregoing embodiment. Details are not described herein again.

The fault determining module 1503 is configured to determine a fault degree of the motor based on the first feature data.

For specific descriptions of the fault determining module 1503, refer to descriptions of step 1303 in the foregoing embodiment. Details are not described herein again.

In a possible implementation, the first current is a stator current of the motor in a first time period, and the obtaining module is further configured to:

obtain a second current, where the second current is a stator current of the motor during normal operation or in a second time period, and the second time period is a time period before the first time period.

The feature extraction module is further configured to:

obtain second feature data of the second current based on the second current, where the second feature data and the first feature data are data of a same type.

The fault determining module is specifically configured to:

determine the fault degree of the motor based on a difference between the first feature data and the second feature data.

In a possible implementation, the second feature data includes a second variation feature, in time domain, of a second phase value corresponding to the second current, the second phase value is a phase in a complex signal obtained by decomposing the second current, and the second variation feature is related to a variation amplitude of the second phase value in time domain.

In a possible implementation, the existing fault degree is represented by a fault level, a fault score, or information about comparison between the fault degree of the electrode and a fault degree of another motor.

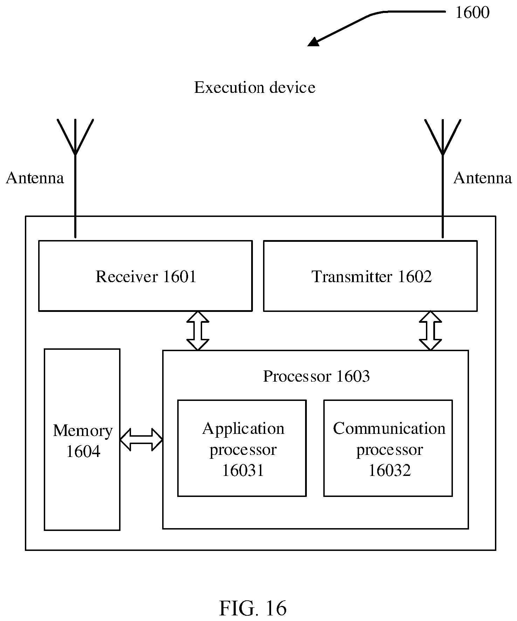

The following describes a fault detection apparatus according to an embodiment of this application. FIG. 16 is a diagram of a structure of an execution device according to an embodiment of this application. Specifically, an execution device 1600 includes a receiver 1601, a transmitter 1602, a processor 1603, and a memory 1604 (there may be one or more processors 1603 in the execution device 1600, and one processor is used as an example in FIG. 16). The processor 1603 may include an application processor 16031 and a communication processor 16032. In some embodiments of this application, the receiver 1601, the transmitter 1602, the processor 1603, and the memory 1604 may be connected through a bus or in another manner.

The memory 1604 may include a read-only memory and a random access memory, and provide instructions and data for the processor 1603. A part of the memory 1604 may further include a non-volatile random access memory (non-volatile random access memory, NVRAM). The memory 1604 stores a processor and operation instructions, executable modules or data structures, or a subset thereof, or an extended set thereof. The operation instructions may include various operation instructions for implementing various operations.

The methods disclosed in embodiments of this application may be applied to the processor 1603 or may be implemented by the processor 1603. The processor 1603 may be an integrated circuit chip and has a signal processing capability. In an implementation process, steps in the foregoing methods may be implemented by using a hardware integrated logic circuit in the processor 1603, or by using instructions in a form of software. The processor 1603 may be a general-purpose processor, a digital signal processor (digital signal processor, DSP), a microprocessor or a microcontroller. The processor 1603 may further include an application-specific integrated circuit (application-specific integrated circuit, ASIC), a field programmable gate array (field programmable gate array, FPGA) or another programmable logic device, a discrete gate or transistor logic device, or a discrete hardware component. The processor 1603 may implement or perform the methods, steps, and logical block diagrams that are disclosed in embodiments of this application. The general-purpose processor may be a microprocessor, or the processor may be any conventional processor or the like. The steps in the methods disclosed with reference to embodiments of this application may be directly performed and completed by a hardware decoding processor, or may be performed and completed by using a combination of hardware in the decoding processor and a software module. The software module may be located in a mature storage medium in the art, such as a random access memory, a flash memory, a read-only memory, a programmable read-only memory, an electrically erasable programmable memory, or a register. The storage medium is located in the memory 1604, and the processor 1603 reads information in the memory 1604, and completes the steps in the fault detection method provided in the foregoing embodiments in combination with hardware of the processor 1603.

The receiver 1601 may be configured to receive input digital or character information, and generate a signal input related to setting and function control of a radar system. The transmitter 1602 may be configured to output the digital or character information through a first interface. The transmitter 1602 may be further configured to send instructions to a disk group through the first interface, to modify data in the disk group.

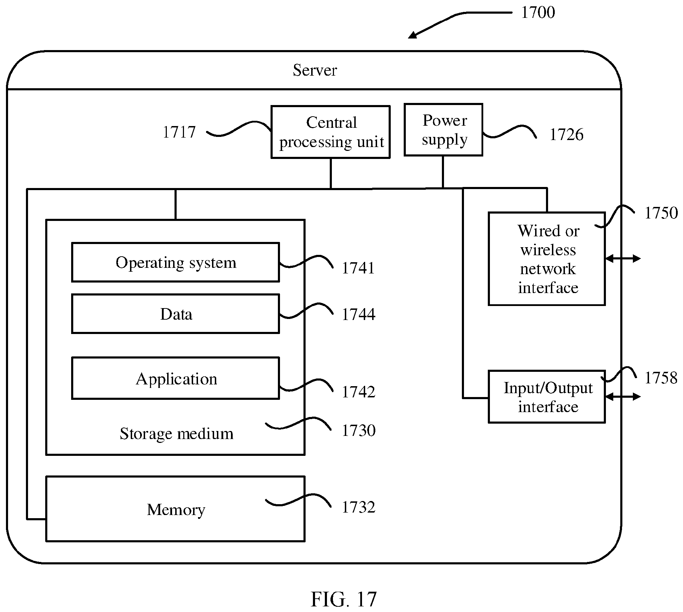

An embodiment of this application further provides a server. FIG. 17 is a diagram of a structure of a server according to an embodiment of this application. The server may vary greatly due to different configurations or performance, and may include one or more central processing units (central processing units, CPU) 1717 (for example, one or more processors) and a memory 1732, and one or more storage media 1730 (for example, one or more mass storage devices) that stores an application 1742 or data 1744. The memory 1732 and the storage medium 1730 may be transitory storage or persistent storage. A program stored in the storage medium 1730 may include one or more modules (not shown in the figure), and each module may include a series of instruction operations for the training device. Further, the central processing unit 1717 may be configured to: communicate with the storage medium 1730, and perform, on the server 1700, the series of instruction operations in the storage medium 1730.

The server 1700 may further include one or more power supplies 1726, one or more wired or wireless network interfaces 1750, one or more input/output interfaces 1758, and/or one or more operating systems 1741, such as Windows ServerTM, Mac OS XTM, UnixTM, LinuxTM, and FreeBSDTM.

In this embodiment of this application, the central processing unit 1717 is configured to perform the data processing method described in the foregoing embodiments.

An embodiment of this application further provides a computer program product. When the computer program product is run on a computer, the computer is enabled to perform the fault detection method described in the foregoing embodiments.

An embodiment of this application further provides a computer-readable storage medium. The computer-readable storage medium stores a program used to perform signal processing. When the program is run on a computer, the computer is enabled to perform the fault detection method described in the foregoing embodiments.

The fault detection apparatus provided in embodiments of this application may be a chip. The chip includes a processing unit and a communication unit. The processing unit may be, for example, a processor, and the communication unit may be, for example, an input/output interface, a pin, a circuit, or the like. The processing unit may execute computer-executable instructions stored in a storage unit, so that a chip in an execution device performs the image enhancement method described in the foregoing embodiments, or a chip in a training device performs the image enhancement method described in the foregoing embodiments. Optionally, the storage unit is a storage unit in the chip, for example, a register or a cache. The storage unit may alternatively be a storage unit located in a wireless access device but outside the chip, for example, a read-only memory (read-only memory, ROM), another type of static storage device capable of storing static information and instructions, or a random access memory (random access memory, RAM).

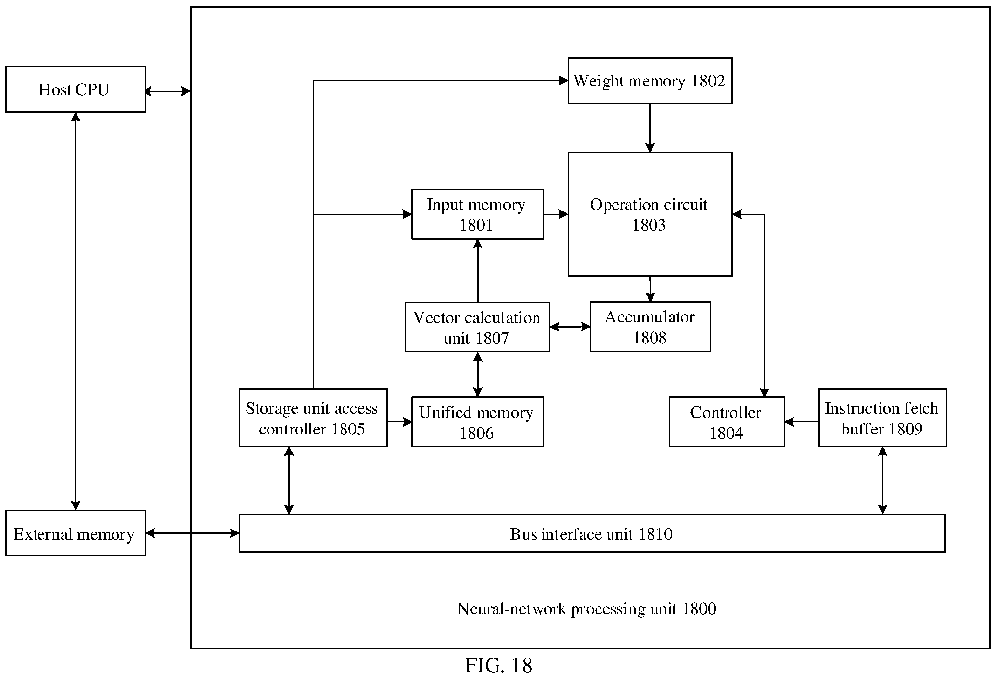

Specifically, FIG. 18 is a diagram of a structure of a chip according to an embodiment of this application. The chip may be represented as a neural-network processing unit NPU 180. The NPU 180 is mounted to a host CPU (Host CPU) as a coprocessor, and the host CPU allocates a task. A core part of the NPU is an operation circuit 1803. A controller 1804 controls the operation circuit 1803 to extract matrix data in a memory and performs a multiplication operation.

In some implementations, the operation circuit 1803 internally includes a plurality of processing units (Process Engine, PE). In some implementations, the operation circuit 1803 is a two-dimensional systolic array. The operation circuit 1803 may alternatively be a one-dimensional systolic array or another electronic circuit that can perform mathematical operations such as multiplication and addition. In some implementations, the operation circuit 1803 is a general-purpose matrix processor.

For example, it is assumed that there is an input matrix A, a weight matrix B, and an output matrix C. The operation circuit fetches, from a weight memory 1802, data corresponding to the matrix B, and caches the data on each PE in the operation circuit. The operation circuit fetches data of the matrix A from an input memory 1801, to perform a matrix operation on the matrix B, and stores an obtained partial result or an obtained final result of the matrix in an accumulator (accumulator) 1808.

A unified memory 1806 is configured to store input data and output data. Weight data is directly transferred to the weight memory 1802 by using a storage unit access controller (direct memory access controller, DMAC) 1805. The input data is also transferred to the unified memory 1806 by using the DMAC.

A BIU is a bus interface unit, namely, a bus interface unit 1810, and is configured to perform interaction between an AXI bus and the DMAC and between the AXI bus and an instruction fetch buffer (Instruction Fetch Buffer, IFB) 1809.

The bus interface unit (Bus Interface Unit, BIU for short) 1810 is used by the instruction fetch buffer 1809 to obtain instructions from an external memory, and is further used by the storage unit access controller 1805 to obtain original data of the input matrix A or the weight matrix B from the external memory.

The DMAC is mainly configured to transfer input data in the external memory DDR to the unified memory 1806, transfer weight data to the weight memory 1802, or transfer input data to the input memory 1801.

A vector calculation unit 1807 includes a plurality of operation processing units, and performs further processing, for example, vector multiplication, vector addition, an exponential operation, a logarithmic operation, or value comparison, on an output of the operation circuit if necessary. The vector calculation unit 1807 is mainly configured to perform network computation at a non-convolutional/fully-connected layer of a neural network, for example, batch normalization (batch normalization), pixel-level summation, and upsampling of a feature plane.

In some implementations, the vector calculation unit 1807 can store a processed output vector in the unified memory 1806. For example, the vector calculation unit 1807 may apply a linear function and/or a non-linear function to the output of the operation circuit 1803. For example, linear interpolation is performed on a feature plane extracted at a convolutional layer. For another example, vectors whose values are accumulated are used to generate an activation value. In some implementations, the vector calculation unit 1807 generates a normalized value, a pixel-level summation value, or both a normalized value and a pixel-level summation value. In some implementations, the processed output vector can be used as an activation input to the operation circuit 1803, for example, used at a subsequent layer in the neural network.

The instruction fetch buffer (instruction fetch buffer) 1809 connected to the controller 1804 is configured to store instructions used by the controller 1804.

The unified memory 1806, the input memory 1801, the weight memory 1802, and the instruction fetch buffer 1809 are all on-chip memories. The external memory is private to a hardware architecture of the NPU.

The processor mentioned anywhere above may be a general-purpose central processing unit, a microprocessor, an ASIC, or one or more integrated circuits for controlling program execution of steps related to the fault detection method described in the foregoing embodiments.

In addition, it should be noted that the apparatus embodiments described above are merely examples. The units described as separate parts may or may not be physically separate, and parts displayed as units may or may not be physical units, that is, may be located at one position, or may be distributed on a plurality of network units. Some or all the modules may be selected according to actual needs to achieve the objectives of the solutions of embodiments. In addition, in the accompanying drawings of the apparatus embodiments provided in this application, connection relationships between modules indicate that the modules have communication connections with each other, which may be specifically implemented as one or more communications buses or signal cables.

Based on the description of the foregoing implementations, a person skilled in the art may clearly understand that this application may be implemented by software in addition to necessary universal hardware, or by dedicated hardware, including an application-specific integrated circuit, a dedicated CPU, a dedicated memory, a dedicated component, and the like. Usually, any function implemented by a computer program may be easily implemented by using corresponding hardware. In addition, specific hardware structures used to implement a same function may be various, for example, an analog circuit, a digital circuit, or a dedicated circuit. However, as for this application, software program implementation is a better implementation in most cases. Based on such an understanding, the technical solutions of this application essentially or the part contributing to the conventional technology may be implemented in a form of a software product. The computer software product is stored in a readable storage medium, for example, a floppy disk, a USB flash drive, a removable hard disk, a ROM, a RAM, a magnetic disk, or an optical disc of a computer, and includes several instructions for instructing a computer device (which may be a personal computer, a training device, a network device, or the like) to perform the methods in embodiments of this application.

All or some of the foregoing embodiments may be implemented by using software, hardware, firmware, or any combination thereof. When software is used to implement embodiments, the foregoing embodiments may be implemented completely or partially in a form of a computer program product.

The computer program product includes one or more computer instructions. When the computer program instructions are loaded and executed on a computer, all or some of the procedures or functions according to embodiments of this application are generated. The computer may be a general-purpose computer, a dedicated computer, a computer network, or other programmable apparatuses. The computer instructions may be stored in a computer-readable storage medium, or may be transmitted from a computer-readable storage medium to another computer-readable storage medium. For example, the computer instructions may be transmitted from a website, computer, training device, or data center to another website, computer, training device, or data center in a wired (for example, a coaxial cable, an optical fiber, or a digital subscriber line (DSL)) or wireless (for example, infrared, radio, or microwave) manner. The computer-readable storage medium may be any usable medium that can be stored by the computer, or a data storage device, such as a training device or a data center, integrating one or more usable media. The usable medium may be a magnetic medium (for example, a floppy disk, a hard disk, or a magnetic tape), an optical medium (for example, DVD), a semiconductor medium (for example, a solid-state drive (Solid-State Drive, SSD)), or the like.

## Claims

1. A fault detection method, wherein the method comprises:

   obtaining a first current, wherein the first current is a stator current of a motor;
   obtaining first feature data of the first current based on the first current, wherein the first feature data is related to a fault of the motor, the first feature data is numerical relationships between a plurality of first harmonic amplitudes and a plurality of first amplitudes of the first current, the plurality of first amplitudes comprise a first fundamental amplitude and a plurality of second harmonic amplitudes of the first current, and the plurality of second harmonic amplitudes are unrelated to the fault of the motor; and
   determining a fault degree of the motor based on the first feature data.

2. The method according to claim 1, wherein the first current is a stator current of the motor in a first time period, and the method further comprises:

   obtaining a second current, wherein the second current is a stator current of the motor during normal operation or in a second time period, and the second time period is a time period before the first time period; and
   the determining a fault degree of the motor based on the first feature data comprises:

   obtaining second feature data of the second current based on the second current, wherein the second feature data and the first feature data are data obtained through calculation in a same manner; and
   determining the fault degree of the motor based on a difference between the first feature data and the second feature data.

3. The method according to claim 1 or 2, wherein the plurality of first amplitudes further comprise the plurality of first harmonic amplitudes.

4. The method according to any one of claims 1 to 3, wherein the numerical relationships between the plurality of first harmonic amplitudes and the plurality of first amplitudes comprise:
   a first difference degree between a first fusion result and a second fusion result, wherein the first fusion result is a fusion result of the plurality of first harmonic amplitudes, and the second fusion result is a fusion result of the plurality of first amplitudes.

5. The method according to any one of claims 1 to 4, wherein the plurality of first harmonic amplitudes are amplitudes of a plurality of first-frequency harmonics in the first current; and
   the second feature data is numerical relationships between a plurality of third harmonic amplitudes of the plurality of first-frequency harmonics and a plurality of second amplitudes of the second current, the plurality of third harmonic amplitudes are amplitudes of the plurality of first-frequency harmonics in the second current, the plurality of second amplitudes comprise a fundamental amplitude and a plurality of harmonic amplitudes of the second current, the plurality of harmonic amplitudes are unrelated to the fault of the motor, and the second current is the stator current of the motor in the absence of fault or in the second time period.

6. The method according to any one of claims 1 to 5, wherein

each of the plurality of first harmonic amplitudes and each of a plurality of corresponding fourth harmonic amplitudes are within a preset numerical range, and each fourth harmonic amplitude is an amplitude of a harmonic of a multiplied frequency of a harmonic frequency corresponding to the first harmonic amplitude; or a fusion result of the plurality of first harmonic amplitudes and the plurality of corresponding fourth harmonic amplitudes is within a preset value range.

7. The method according to any one of claims 1 to 6, wherein the existing fault degree is represented by a fault level, a fault score, or information about comparison between the fault degree of the electrode and a fault degree of another motor.

8. A fault detection method, wherein the method comprises:

obtaining a first current, wherein the first current is a stator current of a motor;
obtaining first feature data of the first current based on the first current, wherein the first feature data comprises a first variation feature, in time domain, of a first phase value corresponding to the first current, the first phase value is a phase in a complex signal obtained by decomposing the first current, and the first variation feature is related to a variation amplitude of the first phase value in time domain; and
determining a fault degree of the motor based on the first feature data.

9. The method according to claim 8, wherein the first current is a stator current of the motor in a first time period, and the method further comprises:

obtaining a second current, wherein the second current is a stator current of the motor during normal operation or in a second time period, and the second time period is a time period before the first time period; and
the determining a fault degree of the motor based on the first feature data comprises:

obtaining second feature data of the second current based on the second current, wherein the second feature data and the first feature data are data obtained through calculation in a same manner; and
determining the fault degree of the motor based on a difference between the first feature data and the second feature data.

10. The method according to claim 8 or 9, wherein the second feature data comprises a second variation feature, in time domain, of a second phase value corresponding to the second current, the second phase value is a phase in a complex signal obtained by decomposing the second current, and the second variation feature is related to a variation amplitude of the second phase value in time domain.

11. A fault detection apparatus, wherein the apparatus comprises:

an obtaining module, configured to obtain a first current, wherein the first current is a stator current of a motor;
a feature extraction module, configured to obtain first feature data of the first current based on the first current, wherein the first feature data is related to a fault of the motor, the first feature data is numerical relationships between a plurality of first harmonic amplitudes and a plurality of first amplitudes of the first current, the plurality of first amplitudes comprise a first fundamental amplitude and a plurality of second harmonic amplitudes of the first current, and the plurality of second harmonic amplitudes are unrelated to the fault of the motor; and
a fault determining module, configured to determine a fault degree of the motor based on the first feature data.

12. The apparatus according to claim 11, wherein the first current is a stator current of the motor in a first time period, and the obtaining module is further configured to:

obtain a second current, wherein the second current is a stator current of the motor during normal operation or in a second time period, and the second time period is a time period before the first time period;
the feature extraction module is further configured to:

obtain second feature data of the second current based on the second current, wherein the second feature data and the first feature data are data obtained through calculation in a same manner; and

the fault determining module is specifically configured to:

determine the fault degree of the motor based on a difference between the first feature data and the second feature data.

13. The apparatus according to claim 11 or 12, wherein the numerical relationships between the plurality of first harmonic amplitudes and the plurality of first amplitudes comprise:

a first difference degree between a first fusion result and a second fusion result, wherein the first fusion result is a fusion result of the plurality of first harmonic amplitudes, and the second fusion result is a fusion result of the plurality of first amplitudes.

14. The apparatus according to any one of claims 11 to 13, wherein the plurality of first harmonic amplitudes are amplitudes of a plurality of first-frequency harmonics in the first current; and

the second feature data is numerical relationships between a plurality of third harmonic amplitudes of the plurality of first-frequency harmonics and a plurality of second amplitudes of the second current, the plurality of third harmonic amplitudes are amplitudes of the plurality of first-frequency harmonics in the second current, the plurality of second amplitudes comprise a fundamental amplitude and a plurality of harmonic amplitudes of the second current, the plurality of harmonic amplitudes are unrelated to the fault of the motor, and the second current is the stator current of the motor in the absence of fault or in the second time period.

15. The apparatus according to any one of claims 11 to 14, wherein

each of the plurality of first harmonic amplitudes and each of a plurality of corresponding fourth harmonic amplitudes are within a preset numerical range, and each fourth harmonic amplitude is an amplitude of a harmonic of a multiplied frequency of a harmonic frequency corresponding to the first harmonic amplitude; or

a fusion result of the plurality of first harmonic amplitudes and the plurality of corresponding fourth harmonic amplitudes is within a preset value range.

16. The apparatus according to any one of claims 11 to 15, wherein the existing fault degree is represented by a fault level, a fault score, or information about comparison between the fault degree of the electrode and a fault degree of another motor.

17. A fault detection apparatus, wherein the apparatus comprises:

an obtaining module, configured to obtain a first current, wherein the first current is a stator current of a motor;

a feature extraction module, configured to obtain first feature data of the first current based on the first current, wherein the first feature data comprises a first variation feature, in time domain, of a first phase value corresponding to the first current, the first phase value is a phase in a complex signal obtained by decomposing the first current, and the first variation feature is related to a variation amplitude of the first phase value in time domain; and

a fault determining module, configured to determine a fault degree of the motor based on the first feature data.

18. The apparatus according to claim 17, wherein the first current is a stator current of the motor in a first time period, and the obtaining module is further configured to:

obtain a second current, wherein the second current is a stator current of the motor during normal operation or in a second time period, and the second time period is a time period before the first time period;

the feature extraction module is further configured to:

obtain second feature data of the second current based on the second current, wherein the second feature data and the first feature data are data obtained through calculation in a same manner; and

the fault determining module is specifically configured to:

determine the fault degree of the motor based on a difference between the first feature data and the second feature data.

19. The apparatus according to claim 17 or 18, wherein the second feature data comprises a second variation feature, in time domain, of a second phase value corresponding to the second current, the second phase value is a phase in a complex signal obtained by decomposing the second current, and the second variation feature is related to a variation amplitude of the second phase value in time domain.

20. The apparatus according to any one of claims 17 to 19, wherein the existing fault degree is represented by a fault level, a fault score, or information about comparison between the fault degree of the electrode and a fault degree of another motor.

21. A fault detection apparatus, comprising one or more processors and a memory, wherein the memory stores computer-readable instructions; and
the one or more processors read the computer-readable instructions, so that the computer device implements the method according to any one of claims 1 to 10.

22. A computer-readable storage medium, comprising computer-readable instructions, wherein when the computer-readable instructions are run on a computer device, the computer device is enabled to perform the method according to any one of claims 1 to 10.

23. A computer program product, comprising computer-readable instructions, wherein when the computer-readable instructions are run on a computer device, the computer device is enabled to perform the method according to any one of claims 1 to 10.

102

101

103

Parameter → Fault detection application → Fault detection result

FIG. 1

Data →

← Processing result

Terminal 100          Server 200

FIG. 2

Terminal 100

(Optional)

110 — Radio
frequency unit

Camera

(Optional)
150

160

Speaker 161

190

170

Microphone
162

Power
supply

Audio
circuit
(Optional)

Headset
jack

163

180 — External
interface

Processor

120 — Memory

(Optional)
131

Touchscreen

130 — Input unit

Display unit

140

Another input
device

132

FIG. 3

FIG. 4

FIG. 5

FIG. 6

```
┌─────────────────────────┐        ┌─────────────────────────┐
│ Electromechanical device│ ─────▶ │     Data collection     │
└─────────────────────────┘        └─────────────────────────┘
                                                │
                                                ▼
┌───────────────────────────────────────────────────────────────┐
│                        Core algorithm                          │
│   ┌──────────────┐   ┌──────────────┐   ┌──────────────┐       │
│   │    Data      │   │   Feature    │   │ Health index │       │
│   │preprocessing │   │  extraction  │   │ calculation  │       │
│   └──────────────┘   └──────────────┘   └──────────────┘       │
│                                                                │
└───────────────────────────────────────────────────────────────┘
```

FIG. 7

```
┌───────────────────────────────────────────────────────────────┐
│  Obtain a first current, where the first current is a stator   │          801
│                     current of a motor                         │
└───────────────────────────────────────────────────────────────┘
                                │
                                ▼
┌───────────────────────────────────────────────────────────────┐
│   Obtain first feature data of the first current based on the  │
│  first current, where the first feature data is related to a   │
│   fault of the motor, the first feature data is numerical      │
│  relationships between a plurality of first harmonic amplitudes│
│   and a plurality of first amplitudes of the first current, the│          802
│  plurality of first amplitudes include a first fundamental     │
│  amplitude and a plurality of second harmonic amplitudes of the│
│  first current, and the plurality of second harmonic amplitudes│
│         are unrelated to the fault of the motor                │
└───────────────────────────────────────────────────────────────┘
                                │
                                ▼
┌───────────────────────────────────────────────────────────────┐
│  Determine a fault degree of the motor based on the first      │          803
│                       feature data                             │
└───────────────────────────────────────────────────────────────┘
```

FIG. 8

FIG. 9

FIG. 10

FIG. 11

**Belt conveyor-motor drive system**

**Device operating status**

Health score: **66/Slightly abnormal**

Motor speed: 600 r/min

Motor temperature: 47°C

**Motor health ranking**

1. Motors of three belt conveyors in a main shaft

2. Motor of No. 5 pumping machine in the main shaft

3. Motor of a ventilation fan in the main shaft

...

FIG. 12

Obtain a first current, where the first current is a stator current of a motor — 1301

Obtain first feature data of the first current based on the first current, where the first feature data includes a first variation feature, in time domain, of a first phase value corresponding to the first current, the first phase value is a phase in a complex signal obtained by decomposing the first current, and the first variation feature is related to a variation amplitude of the first phase value in time domain — 1302

Determine a fault degree of the motor based on the first feature data — 1303

FIG. 13

1400

1401

Obtaining module

1402

Feature extraction module

1403

Fault determining module

FIG. 14

1500

1501

Obtaining module

1502

Feature extraction module

1503

Fault determining module

FIG. 15

1600

Execution device

Antenna                    Antenna

| Receiver 1601 | Transmitter 1602 |
| --- | --- |

Processor 1603

| Memory 1604 | Application processor 16031 | Communication processor 16032 |
| --- | --- | --- |

FIG. 16

1700

Server

1717

Central processing unit

Power supply

1726

Operating system — 1741

Data — 1744

Application — 1742

Storage medium — 1730

Memory — 1732

Wired or wireless network interface — 1750

Input/Output interface — 1758

FIG. 17

FIG. 18

## INTERNATIONAL SEARCH REPORT

| International application No. |
|---|
| **PCT/CN2023/114145** |

### A. CLASSIFICATION OF SUBJECT MATTER

G01R31/34(2020.01)i

According to International Patent Classification (IPC) or to both national classification and IPC

### B. FIELDS SEARCHED

Minimum documentation searched (classification system followed by classification symbols)

IPC: G01R

Documentation searched other than minimum documentation to the extent that such documents are included in the fields searched

Electronic data base consulted during the international search (name of data base and, where practicable, search terms used)

CNABS; CNTXT; CJFD; CNKI; ENTXTC; WPABS; ENTXT; IEEE: 华为, 王萌, 孟超, 陈润昌, 定子, 电流, 故障, 程度, 得分, 等级, 分数, 谐波, 幅值, 幅度, 复数, 相位, 变化, stator, current, fault?, failure, level, harmonic, amplitude, complex, phase, chang+

### C. DOCUMENTS CONSIDERED TO BE RELEVANT

| Category* | Citation of document, with indication, where appropriate, of the relevant passages | Relevant to claim No. |
|---|---|---|
| X | CN 103926533 A (HOHAI UNIVERSITY) 16 July 2014 (2014-07-16) description, paragraphs [0031]-[0035] and [0090] | 1-3, 5, 7, 11, 12, 14, 16, 21-23 |
| A | CN 113484606 A (DONGFANG HITACHI (CD) ELECTRIC CONTROL EQUIPMENTS CO., LTD.) 08 October 2021 (2021-10-08) entire document | 1-23 |
| A | CN 114487911 A (SANY AUTOMOBILE HOISTING MACHINERY CO., LTD.) 13 May 2022 (2022-05-13) entire document | 1-23 |
| A | US 2016266208 A1 (ROLLS ROYCE PLC.) 15 September 2016 (2016-09-15) entire document | 1-23 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **28 September 2023** | **10 November 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

| International application No. |
| --- |
| **PCT/CN2023/114145** |

| Patent document cited in search report | | | Publication date (day/month/year) | Patent family member(s) | Publication date (day/month/year) |
| --- | --- | --- | --- | --- | --- |
| CN | 103926533 | A | 16 July 2014 | None | |
| CN | 113484606 | A | 08 October 2021 | None | |
| CN | 114487911 | A | 13 May 2022 | None | |
| US | 2016266208 | A1 | 15 September 2016 | None | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211048338